(19) Europäisches Patentamt / European Patent Office / Office européen des brevets

(11) **EP 3 917 048 B1**

(12) **EUROPÄISCHE PATENTSCHRIFT**

(45) Veröffentlichungstag und Bekanntmachung des Hinweises auf die Patenterteilung:
**09.08.2023   Patentblatt 2023/32**

(21) Anmeldenummer: **21174846.2**

(22) Anmeldetag: **19.05.2021**

(51) Internationale Patentklassifikation (IPC):
*H04L 1/00* (2006.01)   *H03M 13/09* (2006.01)
*H04L 1/02* (2006.01)   *H03M 13/35* (2006.01)
*H03M 13/37* (2006.01)

(52) Gemeinsame Patentklassifikation (CPC):
**H04L 1/0061; H03M 13/09; H03M 13/356; H03M 13/3761; H04L 1/0059; H04L 1/0072; H04L 1/02**

(54) **VERFAHREN SOWIE VORRICHTUNGEN ZUM ÜBERTRAGEN VON DATEN**

DEVICES AND METHOD FOR TRANSFERRING DATA

PROCÉDÉS, AINSI QUE DISPOSITIFS DE TRANSMISSION DE DONNÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.05.2020   DE 102020003290**

(43) Veröffentlichungstag der Anmeldung:
**01.12.2021   Patentblatt 2021/48**

(73) Patentinhaber: **Diehl Metering GmbH**
**91522 Ansbach (DE)**

(72) Erfinder:
- **Petkov, Hristo**
  **90425 Nürnberg (DE)**
- **Mzyk, Raphael**
  **91126 Kammerstein (DE)**
- **Kauppert, Thomas**
  **90455 Nürnberg (DE)**
- **Gottschalk, Klaus**
  **90610 Winkelhaid (DE)**
- **Kilian, Gerd**
  **91056 Erlangen (DE)**
- **Bernhard, Josef**
  **92507 Nabburg (DE)**
- **Kneißl, Jakob**
  **90765 Fürth (DE)**
- **Wechsler, Johannes**
  **91174 Spalt (DE)**
- **Ereth, Stefan**
  **90768 Fürth (DE)**
- **Soller, Dominik**
  **90571 Schwaig (DE)**
- **Breiling, Marco**
  **91052 Erlangen (DE)**

(74) Vertreter: **Diehl Patentabteilung**
**c/o Diehl Stiftung & Co. KG**
**Stephanstraße 49**
**90478 Nürnberg (DE)**

(56) Entgegenhaltungen:
**EP-A1- 3 342 080**

- **GIRS SVETLANA ET AL: "Adopting FEC and packet combining to increase the performance of IWSNs using relaying", 2015 INTERNATIONAL CONFERENCE ON COMPUTING AND NETWORK COMMUNICATIONS (COCONET), IEEE, 16. Dezember 2015 (2015-12-16), Seiten 90-97, XP032866174, DOI: 10.1109/COCONET.2015.7411172 [gefunden am 2016-02-17]**

**Beschreibung**

Die vorliegende Erfindung betrifft ein Verfahren zum Übertragen von Daten gemäß Anspruch 1 sowie Anspruch 11. Ferner betrifft die vorliegende Erfindung einen Sender gemäß Anspruch 15, einen Empfänger gemäß Anspruch 17, ein System gemäß Anspruch 20 sowie ein Computerprogramm gemäß Anspruch 21.

Technologischer Hintergrund

Eine Herausforderung bei dem Aufbau eines "Internet der Dinge", dem sog. IoT, ist es, dass eine Vielzahl an Knoten mit dem Internet verbunden wird. Diese Knoten können zum Beispiel für die Erfassung von Sensordaten wie Temperatur, Wasservolumen, Füllstand eines Mülleimers, die Position eines Haustieres und anderer Parameter eingesetzt werden. Viele dieser Knoten kommunizieren per Funk mit einer Basisstation, um Daten auszutauschen. Auf Basis dieser Daten können beispielsweise kritische Situationen, wie z. B. Wasserleckagen oder Gasleckagen erkannt werden. Dadurch könnte eine Nachricht von dem Knoten ausgesandt werden, um einen Schalter oder ein Ventil zu betätigen, welche die Leckage stoppen und somit größere Schäden verhindert werden können. Ferner ist auch eine Anbindung an die Leitstelle von Rettungskräften, wie der Feuerwehr oder dem Notarzt, möglich.

Aus diesem Grunde ist es wichtig, dass diese kritischen Situationen zuverlässig erkannt werden und keine falschen Alarme ausgelöst werden, die mit unnötigen Kosten verbunden sind. Bei einer sehr großen und wachsenden Zahl von IoT-Geräten muss die Wahrscheinlichkeit des Auftretens eines falschen Alarms möglichst gering gehalten werden.

Um fehlerhafte Datenpakete zu erkennen, können Verfahren zur Erkennung von Fehlern bei der Übertragung der Daten verwendet werden. Ein Verfahren ist die zyklische Redundanzprüfung (CRC), die beispielsweise so ausgelegt ist, dass Fehler bei der Übertragung von Daten, wie sie beispielsweise durch Rauschen auf der Leitung verursacht werden könnten, mit hoher Wahrscheinlichkeit entdeckt werden. Hierfür wird vor der Übertragung für jeden Datenblock eine zusätzliche Redundanz in Form eines sogenannten CRC-Wertes angefügt. Es verbleibt allerdings eine Wahrscheinlichkeit, dass ein fehlerhaftes Paket als gültiges Paket ("false positive") akzeptiert wird. Diese Wahrscheinlichkeit kann mit $P_{fp} = 2^{-L}$ angegeben werden, wobei L die Länge des CRC-Wertes, angegeben in Bits, beträgt.

Nächstliegender Stand der Technik

In der DE 10 2010 031 411 B4 werden Verfahren sowie Sender und Empfänger offenbart, durch die es möglich ist, bei unkoordinierter Übertragung eine Kombination mehrerer codierter Datenpakete vorzunehmen, um somit einen Codegewinn, z. B. bei Störungen oder niedrigen Signalpegeln, am Empfänger zu erhalten. Dies wird mittels Code Combining (inkrementeller Redundanz) erreicht.

Ausgangsbasis dieses Code Combinings ist ein gemeinsames Codewort, das das Ergebnis des Encoders der FEC ("forward error correction") ist, und welches auf mindestens zwei Datenpakete so verteilt wird, dass jedes Datenpaket für sich selbst decodierbar ist. Sofern die mindestens zwei Datenpakete einzeln fehlerhaft decodiert werden, kann durch die Kombination der Datenpakete ein Codegewinn erzielt werden.

Damit jedes Datenpaket für sich selbst detektierbar und die Informationen für das Code Combining decodierbar sind, ist jedes Datenpaket mit einem Kernpaket versehen, welches eine höhere Codierung als die Nutzdaten aufweist. Wenn am Empfänger ein Kerndatenpaket korrekt erkannt wird, aber die Nutzdaten jedoch nicht korrekt decodiert werden, wird das Datenpaket vorerst gespeichert, bis mindestens ein weiteres Datenpaket empfangen wird, welches die gleichen Informationen im Kerndatenpaket enthält. Um zu prüfen, ob zwei Pakete zusammen gehören, wird eine Kennung (z. B. eine ID) verglichen. Sofern mindestens zwei zusammengehörige Datenpakete gefunden werden, kann eine gemeinsame Decodierung mittels Code Combining erfolgen.

GIRS SVETLANA ET AL: "Adopting FEC and packet combining to increase the performance of IWSNs using relaying", 2015 INTERNATIONAL CONFERENCE ON COMPUTING AND NETWORK COMMUNICATION (COCONET), IEEE, 16. Dezember 2015 (2015-12-16), Seiten 90-97, DOI:10.1109/COCONET.2015.7411172 beschreibt ein Bitübertragungsschicht (physical (PHY) layer) Vorwärts-Fehlerkorrektur (FEC) Protokoll, welches eine Rahmenstruktur aus Nutzdaten und Kerndaten enthält und eine Datenpaketkombination (packet combining) für die Mehrzahl kanalcodierter Datenpakete aus den Nutzdaten umfasst. Eine Blockprüfzeichenfolge (FCS) wird hierbei in zwei verschiedenen Teilen des Rahmens kodiert und positioniert. Diese beiden Teile werden mit der gleichen Coderate kodiert, da nur eine Kodierung für die Nutzlast durchgeführt wird.

Die WO 2017/035297 A1 offenbart ein Verfahren zur drahtlosen Kommunikation eines drahtlosen Geräts, das mit einem Overlapping Basic Service Set (OBSS) verbunden ist.

Aufgabe der vorliegenden Erfindung

Die Aufgabe der vorliegenden Erfindung besteht darin, neuartige Verfahren sowie Sender und Empfänger zur Verfügung zu stellen, bei denen die Wahrscheinlichkeit für fälschlicherweise als gültig angenommene Daten reduziert wird, und gleichzeitig die Kompatibilität nicht eingeschränkt und die Datenverarbeitungsleistung nicht abgesenkt wird.

## Lösung der Aufgabe

Die vorstehende Aufgabe wird durch ein Verfahren gemäß Anspruch 1, ein Verfahren gemäß Anspruch 11, durch einen Sender gemäß Anspruch 15 und einen Empfänger gemäß Anspruch 17 sowie ein System gemäß Anspruch 20 und ein Computerprogramm gemäß Anspruch 21 gelöst. Zweckmäßige Ausgestaltungen der Erfindung sind in den entsprechenden Unteransprüchen beansprucht.

Erfindungsgemäß ist ein Verfahren zum Übertragen von Nutzdaten innerhalb eines Zeitintervalls T über einen Kommunikationskanal zu einem Empfänger vorgesehen, mit folgenden Schritten:
Erzeugen einer Mehrzahl kanalcodierter Datenpakete aus den Nutzdaten, wobei jedes der kanalcodierten Datenpakete mit Paketkerndaten entsprechend der Paketkennung des jeweiligen kanalcodierten Datenpakets versehen ist, wobei kennzeichnenderweise Redundanzinformationen der Nutzdaten, insbesondere Informationen zur Fehlererkennung, insbesondere Informationen zur zyklischen Redundanzprüfung (CRC), und/oder davon abgeleitete Werte, insbesondere von Informationen zur zyklischen Redundanzprüfung (CRC) abgeleiteten Werten, als Paketkennung oder als Teil der Paketkennung in den Paketkerndaten verwendet werden und die Redundanzinformationen der Nutzdaten, insbesondere Informationen zur Fehlererkennung, in mindestens zwei Teilen des Datenpakets, insbesondere in zwei nicht benachbarten Teilen, übertragen werden, wobei diese zwei Teile des Datenpakets mit gleicher Coderate der Kanalkodierung codiert sind.

Zweckmäßigerweise kann es sich bei den zwei Teilen des Datenpakets, in denen die Redundanzinformationen der Nutzdaten übertragen werden, um nicht benachbarte Teile handeln. Dies bedeutet, dass die Teile innerhalb des Datenpakets beabstandet sind, diese also einen Abstand zueinander aufweisen, so dass beispielsweise mindestens ein anderer Teil zwischen diesen beiden Teilen im Datenpaket angeordnet ist. Diese zwei Teile folgen somit nicht unmittelbar aufeinander innerhalb des Datenpakets.

Im Kerndatenpaket können neben der Kennung (ID) noch weitere Informationen enthalten sein, die nicht in allen Datenpaketen gleich sind. Für das Code Combining ist es allerdings unerheblich, ob die Kennung (ID) für einen Teilnehmer (Sender) immer gleich ist oder diese sich bei verschiedenen Telegrammen ändert. Telegramme sind hierbei von Datenpaketen zu unterscheiden: Telegramme bezeichnen übergeordnet eine neue Übertragung mit neuen Nutzdaten. Ein Telegramm kann somit mehrere Datenpakete umfassen. Es besteht somit die Möglichkeit, jede beliebige Information, die in allen Kerndatenpaketen gleich ist, für das Code Combining zu verwenden.

Eine Information, die in jedem Datenpaket übertragen wird, ist die Redundanzinformation der Nutzdaten. Diese Redundanzinformation wird erfindungsgemäß direkt in den Paketkerndaten als Kennung oder als Teil der Kennung übertragen. Das Code Combining kann immer noch genauso durchgeführt werden, nur dass die Kennung nun nicht mehr einem Knoten zugeordnet werden kann. Die Länge der übertragenen Daten kann somit reduziert werden, ohne Einbußen in der Qualität der Übertragung bzw. in der Performance zu haben.

Redundante Informationen können einerseits zur Fehlererkennung und Fehlerbehebung dienen, wie beispielsweise zur zyklischen Redundanzprüfung (CRC). Andererseits können durch Kanalcodierungen redundante Informationen hinzugefügt werden, welche beispielsweise beim Decodieren der übertragenen Daten Anwendung finden.

Zweckmäßigerweise können die abgeleiteten Werte, insbesondere von Informationen zur zyklischen Redundanzprüfung (CRC) abgeleitete Werte, beispielsweise eine Transformation von CRC-Werten umfassen.

Vorteilhafterweise kann ein erster Teil der Redundanzinformationen der Nutzdaten als Paketkennung in den Paketkerndaten verwendet werden und ein zweiter Teil der Redundanzinformationen der Nutzdaten im Nutzdatenbereich übertragen werden.

Für den Fall, dass die Redundanzinformation der Nutzdaten länger ist bzw. mehr Bits umfasst als für die Kennung in den Kerndaten vorgesehen ist, besteht vorteilhafterweise die Möglichkeit, nur einen Teil der Redundanzinformation der Nutzdaten als Kennung in den Kerndaten für das Code Combining zu verwenden. Der verbleibende Teil der Redundanzinformation der Nutzdaten wird im Nutzdatenbereich übertragen, vorzugsweise nach den Nutzdaten. Zweckmäßigerweise können die Redundanzinformationen der Nutzdaten im Kernteil mit den Redundanzinformationen der Nutzdaten im Nutzdatenbereich teilweise identisch oder nicht identisch sein.

Durch die Erweiterung bzw. die Verteilung der Redundanzinformation der Nutzdaten auf die Paketkennung der Paketkerndaten können die Redundanzinformationen um weitere Bits erweitert werden, um beispielsweise die Detektion von fälschlicherweise als gültig angenommenen Werten ("false positives") zu verbessern. Angenommen, die Redundanzinformation der Nutzdaten umfasse 16 Bits, die durch die erweiterte Verteilung auf die Paketkerndaten um 14 Bits erhöht werden kann. Die Summe der Bits, die für Redundanzinformationen der Nutzdaten zur Verfügung steht, beträgt hierbei z. B. 30 Bits. Dabei ergebe sich bei der Verwendung einer zyklischen Redundanzprüfung beispielsweise eine Wahrscheinlichkeit eines fälschlicherweise als gültig angenommen Wertes ("false positives") von $P_{fp} = 2^{-30} \approx 9,31 \cdot 10^{-10}$.

IoT-Knoten, wie beispielsweise Wasserzähler, senden üblicherweise alle 8 Sekunden einen neuen Messwert. Dadurch akkumulieren sich pro Tag 10800 Datentelegramme. In einer beispielhaften Großstadt mit 1 Million Einwohnern und beispielsweise 5 IoT-Knoten pro Einwohner existieren somit 5 Million Knoten. Angenommen, die Redundanzinformation der Nutzdaten umfasse 30 Bits, so beläuft sich die Anzahl fälschlicherweise als gültig angenommener Werte ("false positives") gemäß $N_{fp\_pday} = N_{telegrams} \cdot N_{nodes} \cdot P_{fp\_30} = 10800 \cdot 5 \cdot 10^6 \cdot 2^{-30} \approx 50{,}29$ auf etwa 50 falsche Werte pro Tag.

Um diese Zahl noch weiter zu senken, können die nachfolgend beschriebenen Optimierungen für codierte Datenpakete angewandt werden.

Zweckmäßigerweise können die Redundanzinformationen der Paketkerndaten, insbesondere Informationen zur Fehlererkennung, insbesondere Informationen zur zyklischen Redundanzprüfung (CRC), mit den Paketkerndaten übertragen werden. Die Kerndaten und die Nutzdaten werden mit unterschiedlichen Kanalcodes codiert, wobei der Kanalcode der Kerndaten eine höhere Redundanz aufweist, als derjenige der Nutzdaten. Dadurch werden die Kerndaten mit kanalcodierten Redundanzinformationen, insbesondere Informationen zur Fehlererkennung, insbesondere Informationen zur zyklischen Redundanzprüfung (CRC), versehen, welche sich von den kanalkodierten Redundanzinformationen, insbesondere Informationen zur Fehlererkennung, insbesondere Informationen zur zyklischen Redundanzprüfung (CRC), der Nutzdaten unterscheiden.

Vorteilhafterweise kann die Mehrzahl der kanalcodierten Datenpakete in dem Zeitintervall T zu dem Empfänger gesendet werden, wobei das Senden der Mehrzahl der kanalcodierten Datenpakete im Hinblick auf Inhalt und Sendezeitpunkte unabhängig von einem Rückkanal von dem Empfänger zu dem Sender in dem Zeitintervall T erfolgt. Derartige unidirektionale Mehrpunkt-zu-Punkt-Kommunikationssysteme eignen sich besonders für eine kostengünstige Übertragung von kleinen Nutzdatenmengen, wie sie z. B. bei Messgeräten, wie beispielsweise Heizungs-, Strom- oder Wasserzählern, anfallen.

Zweckmäßigerweise können die kanalcodierten Datenpakete mittels eines Faltungscodes und eines Punktierungsschemas aus den Nutzdaten erzeugt werden, so dass jedes kanalcodierte Datenpaket einer vorgegebenen Gruppe von kanalcodierten Datenpaketen, die auf zugehörigen Nutzdaten basieren, unabhängig von den anderen kanalcodierten Datenpaketen der Gruppe decodierbar ist. Es besteht ferner die Möglichkeit, dass alle möglichen Kombinationen der Datenpakete durch Rückführung der Punktierung, der sogenannten Depunktierung, dekodierbar sind. Werden beispielsweise die Nutzdaten durch einen Faltungscode der Rate $R = \frac{1}{2}$ codiert, so ist die Anzahl der codierten Nutzdaten daher doppelt so groß wie die Anzahl der nicht codierten Nutzdaten. Wird nun diese doppelte Anzahl an codierten Nutzdaten in zwei Datenpaketen übertragen, so ist die Länge eines Datenpakets gleich der Länge der uncodierten Nutzdaten. Betrachtet man die Coderate zwischen den uncodierten Nutzdaten und den codierten Nutzdaten eines Datenpakets, so ergibt sich die Coderate R = 1. Die Aufteilung der Daten auf diese zwei Datenpakete kann so durchgeführt werden, dass jedes Datenpaket für sich decodierbar ist und bei der Kombination der beiden Datenpakete im Empfänger die Coderate $R = \frac{1}{2}$ entsteht. Es erfolgt somit eine Aufteilung der codierten Nutzdaten auf zwei Datenpakete, die zu unterschiedlichen Zeiten vom Sender ausgesendet werden. Bei inkrementell gesendeten Redundanzinformation kann die durch Kombination resultierende effektive Coderate R' an die Kanal- bzw. Übertragungseigenschaften angepasst werden.

Es besteht die Möglichkeit, dass mindestens eine vorgegebene Auswahl von Kombinationen der kanalcodierten Datenpakete, die auf den zugehörigen Nutzdaten basieren, decodierbar ist. So kann zumindest eine vorgegebene Gruppe oder alle der codierten Datenpakete so ausgestaltet sein, dass diese jeweils bei einer Übertragung für sich alleine auf der Empfängerseite decodierbar sind, um die zugehörigen Nutzdaten zu erhalten. Darüber hinaus kann auch eine vorgegebene Auswahl der codierten weiteren Datenpakete beispielsweise durch Rückführung der Punktierung kombinierbar und decodierbar sein.

Besonders zweckmäßig ist es, dass es sich bei den Redundanzinformationen der Nutzdaten um Informationen zur zyklischen Redundanzprüfung (CRC), insbesondere in Form von angefügten CRC-Werten, handelt. Die Kerndaten und die Nutzdaten werden mit jeweils einem getrennten CRC-Wert versehen. Es ergibt sich somit eine zweistufige CRC-Wert Berechnung. Zunächst kann für die Nutzdaten ein CRC-Wert berechnet werden. Dieser CRC-Wert kann als Paketkennung in den Paketkerndaten verwendet werden. Es besteht auch die Möglichkeit, dass lediglich ein Teil des CRC-Werts der Nutzdaten als Paketkennung verwendet wird und beispielsweise der verbleibende Teil im Nutzdatenbereich übertragen wird. Anschließend kann für die Paketkerndaten ein separater CRC-Wert (Kern-CRC) berechnet werden. Diese Kern-CRC kann für jedes Datenpaket unterschiedlich sein, da im Kerndatenpaket neben der Paketkennung, für welche beispielsweise der CRC-Wert oder ein Teil des CRC-Werts der Nutzdaten verwendet wird, noch weitere Informationen enthalten sein können, die nicht in allen Datenpaketen gleich sind, wie beispielsweise die Slot-Nummer. Diese weiteren Informationen können beispielsweise die ID des betreffenden Senders bzw. Sensors umfassen.

Vorteilhafterweise kann mindestens ein Teil der Redundanzinformationen der Nutzdaten, insbesondere die CRC-Daten, in den Paketkerndaten effektiv mit der gleichen Coderate der Kanalkodierung codiert sein wie die Redundanzinformationen der Nutzdaten im Nutzdatenbereich. Die Kerndaten werden benötigt, um die Nutzdaten von mehreren Paketen zu kombinieren. Deshalb sind die Kerndaten durch eine entsprechende bessere Kanalkodierung geschützt. Im Kern eines jeden Pakets werden die gleichen kanalkodierten Daten des Kerns, die Redundanzinformation der Nutzdaten oder ein Teil der Redundanzinformationen der Nutzdaten, als Bits übertragen. Dagegen werden die kanalkodierten Nutzdaten im Nutzdatenbereich nicht am Stück übertragen. Die Nutzdaten sind als Bits über mehrere Datenpakete verteilt. Mit jedem weiteren empfangenen Datenpaket erreichen den Empfänger weitere bis zu diesem Zeitpunkt nicht bekannte kanalkodierte Bits der Nutzdaten. Die Kodierung der Redundanzinformation der Nutzdaten im Kern und im Nutzdatenbereich ist somit sehr unterschiedlich. Die schlechtere Kodierung bestimmt dabei die Datenverarbeitungsleistung bzw. die Reichweite der Übertragung. Die Redundanzinformation der Nutzdaten im Kernbereich ist für übliche Anwendungsfälle übermäßig gut geschützt im Vergleich zu den Redundanzinformationen der Nutzdaten im Nutzdatenbereich. Vorteilhafterweise kann die Kodierung der Redundanzinformationen der Nutzdaten im Kernbereich an die Kodierung der Redundanzinformationen der Nutzdaten im Nutzdatenbereich angeglichen werden oder effektiv mit der gleichen Redundanz codiert werden. Durch das Herabsetzen der effektiven Redundanz bzw. der effektiven Coderate in den Kerndaten können mehr Daten in den Kerndaten übermittelt werden. Es können somit beispielsweise mehr Redundanzinformationen der Nutzdaten bzw. mehr CRC-Bits in den Paketkerndaten transportiert werden. Es besteht dadurch z. B. auch die Möglichkeit den zusätzlichen Platz bzw. die zusätzlichen Bits in den Paketkerndaten für Daten anderer Art oder für andere Zwecke zu verwenden.

Es besteht zudem die Möglichkeit, dass ein erster Teil der Redundanzinformationen, insbesondere die CRC-Daten, der Nutzdaten in den Paketkerndaten effektiv mit der gleichen Redundanz codiert ist wie die Redundanzinformationen, insbesondere die CRC-Daten, der Nutzdaten im Nutzdatenbereich und ein zweiter Teil der Redundanzinformationen, insbesondere die CRC-Daten, der Nutzdaten in den Paketkerndaten mit einem Kanalcode höherer Redundanz codiert ist.

Zweckmäßigerweise kann mindestens ein erster Teil der Paketkerndaten mit einem Kanalcode höherer Redundanz codiert sein als die kanalkodierten Nutzdaten in einem Nutzdatenbereich, und mindestens ein zweiter Teil der Paketkerndaten mit einem Kanalcode gleicher Redundanz codiert sein wie die kanalkodierten Nutzdaten im Nutzdatenbereich.

Ferner besteht die Möglichkeit, dass der erste Teil der Paketkerndaten, der mit einem Kanalcode höherer Redundanz als die kanalkodierten Nutzdaten im Nutzdatenbereich codiert ist, als Paketkennung in den Paketkerndaten verwendet wird.

Zweckmäßigerweise können die Redundanzinformationen der Nutzdaten, insbesondere die CRC-Daten, für die Übertragung in den Paketkerndaten vorbereitet werden: Kodierung der Redundanzinformationen der Nutzdaten, insbesondere die CRC-Daten, mit dem Kanalcode der Nutzdaten; Transformation der mit dem Kanalcode der Nutzdaten codierten Redundanzinformationen der Nutzdaten, um anschließend mit dem Kanalcode der Paketkerndaten codiert zu werden. Es besteht die Möglichkeit, dass die codierten Redundanzinformationen der Nutzdaten im Zuge der Transformation mit dem Kanalcode der Paketkerndaten decodiert werden.

Vorteilhafterweise kann für die Kanalcodierung der Redundanzinformationen, insbesondere die CRC-Daten, der Nutzdaten in den Paketkerndaten und für die Kanalcodierung der Redundanzinformationen, insbesondere die CRC-Daten, der Nutzdaten im Nutzdatenbereich ein gemeinsames Generatorpolynom verwendet werden. Ferner besteht alternativ oder zusätzlich die Möglichkeit, dass für die Erzeugung der Redundanzinformationen, insbesondere Informationen zur Fehlererkennung, insbesondere Informationen zur zyklischen Redundanzprüfung (CRC), der Nutzdaten in den Paketkerndaten und für die Erzeugung der Redundanzinformationen, insbesondere Informationen zur Fehlererkennung, insbesondere Informationen zur zyklischen Redundanzprüfung (CRC), der Nutzdaten im Nutzdatenbereich ein gemeinsames Generatorpolynom verwendet wird. Beispielsweise beruht die Erzeugung der CRC-Werte als Redundanzinformationen auf Polynomdivision. Aus einem Generatorpolynom mit einem höheren Grad können alle Teil-Generatorpolynome mit geringerem Grad generiert werden. Beispielsweise kann ein Generatorpolynom zur Berechnung einer 32-Bit CRC verwendet werden. Die Teil-Generatorpolynome könnten beispielsweise zur Berechnung einer 16-Bit CRC dienen. Eine 32-Bit CRC bietet allerdings einen besseren Schutz als zwei 16-Bit CRC. So kann mittels einer 32-Bit CRC Burst Fehler in der Größenordnung von 32-Bits erkannt werden, wohingegen mittels zwei 16-Bit CRC lediglich Burst Fehler in der Größenordnung von 16 Bits erkannt werden können. Sofern für bereits implementierte Generatorpolynome, z. B. für 16-Bit CRC, ein übergeordnetes Generatorpolynom, z. B. für 32-Bit CRC, verwendet wird, muss dieses durch Multiplikation des implementierten Generatorpolynoms, z. B. für 16-Bit CRC, mit einem weiteren neuen Generatorpolynom bestimmbar sein. Sollte allerdings keine Rückwärtskompatibilität mit einem bereits implementierten Generatorpolynom gewünscht sein, kann ein neues unabhängiges Generatorpolynom, z. B. für 32-Bit CRC, bestimmt werden. Somit ist es nicht mehr notwendig, für die Codierung unterschiedliche Generatorpolynome zu verwenden, sondern für die Redundanzinformationen in den Paketkerndaten sowie für die Redundanzinformationen im Nutzdatenbereich dasselbe Generatorpolynom zu verwenden.

Nebengeordnet beansprucht die vorliegende Erfindung zudem ein Verfahren zum Empfangen von Nutzdaten, welche insbesondere gemäß einem der Ansprüche 1 bis 10 über einen Kommunikationskanal übertragen werden, mit folgenden Merkmalen: Empfangen einer Mehrzahl kanalcodierter Datenpakete in dem Zeitintervall T; Decodieren von Paketkerndaten eines ersten kanalcodierten Datenpakets des Zeitintervalls T; und im Fall eines Scheiterns eines Decodierens des ersten kanalcodierten Datenpakets, Decodieren von Paketkerndaten mindestens eines zweiten kanalcodierten Datenpakets des Zeitintervalls T, um ein geeignetes weiteres kanalcodiertes Datenpaket des Zeitintervalls für eine Kombination mit dem ersten kanalcodierten Datenpaket zu ermitteln, um aufgrund der Kombination einen erhöhten Codegewinn für eine Decodierung der Nutzdaten zu erhalten, wobei kennzeichnenderweise zum Decodieren eines kanalcodierten Datenpakets die Redundanzinformationen der Nutzdaten, insbesondere Informationen zur Fehlererkennung, insbesondere Informationen zur zyklischen Redundanzprüfung (CRC), und/oder davon abgeleitete Werte, insbesondere von Informationen zur zyklischen Redundanzprüfung (CRC) abgeleiteten Werten, welche als Paketkennung oder als Teil der Paketkennung in den Paketkerndaten dienen und in mindestens zwei Teilen des Datenpakets, insbesondere in zwei nicht benachbarten Teilen, übertragen werden, verwendet werden.

Zweckmäßigerweise können mit dem Verfahren Nutzdaten empfangen werden, die innerhalb eines Zeitintervalls T von einem Sender mittels einer Mehrzahl kanalcodierter Datenpakete über einen, insbesondere verrauschten, Kommunikationskanal zu einem Empfänger übertragen werden, wobei jedes der kanalcodierten Datenpakete Paketkerndaten entsprechend einer für jedes Datenpaket unterschiedlichen Paketkennung und/oder entsprechend der Paketkennung des jeweiligen kanalcodierten Datenpakets aufweist, und wobei die Paketkerndaten mit einem Kanalcode höherer Redundanz codiert sind als die Nutzdaten.

Zweckmäßigerweise kann das Dekodieren der Paketkerndaten unabhängig von einem Rückkanal von dem Empfänger zu dem Sender erfolgen, ohne dass ein erneutes Senden eines kanalcodierten Datenpakets im Fall einer fehlgeschlagenen Decodierung der Nutzdaten veranlasst wird.

Besonders zweckmäßig ist es, wenn ein kanalcodiertes Datenpaket einer vorgegebenen Gruppe von kanalcodierten Datenpaketen, die auf zugehörigen Nutzdaten basieren, unabhängig von den anderen kanalcodierten Datenpaketen der Gruppe decodiert wird. Zweckmäßigerweise kann eine vorgegebene Auswahl von Kombinationen der kanalcodierten Datenpakete, die auf zugehörigen Nutzdaten basieren, decodiert werden.

Vorteilhafterweise kann zur Überprüfung der Decodierung eines kanalcodierten Datenpakets ein Bitvergleich der Redundanzinformationen der Nutzdaten mit mindestens einem zweiten kanalcodierten Datenpaket des Zeitintervalls T durchgeführt werden. Zweckmäßigerweise kann hierfür ein Bitvergleich der Redundanzinformationen der Nutzdaten in den jeweiligen Paketkerndaten und/oder ein Bitvergleich der Redundanzinformationen der Nutzdaten in den jeweiligen Nutzdatenbereichen durchgeführt werden. Beispielsweise kann das Datenpaket bzw. das Telegramm verworfen werden, sofern die Bits nicht identisch sind, also nicht 1 zu 1 übereinstimmen. Bei der Überprüfung können verschiedene Kombinationen ausgewertet werden. So können beispielsweise in einem ersten Fall die Gültigkeit der Redundanzinformationen der Nutzdaten im Kernteil und die Redundanzinformationen der Nutzdaten im Nutzdatenbereich ausreichend sein. In einer anderen Kombination, welche einen zweiten Fall darstellt, kann es ausreichend sein, wenn die Redundanzinformationen der Nutzdaten im Kernteil und die Redundanzinformationen der Nutzdaten im Nutzdatenbereich sowie die Redundanzinformationen der Nutzdaten im Kernteil von zwei Datenpaketen übereinstimmen. In einem dritten Fall kann es ausreichend sein, wenn die Redundanzinformationen der Nutzdaten im Kernteil und die Redundanzinformationen der Nutzdaten im Nutzdatenbereich gültig sind, die Redundanzinformationen der Nutzdaten im Kernteil von zwei Datenpaketen übereinstimmen und die Redundanzinformationen der Nutzdaten im Nutzdatenbereich übereinstimmen. In einem weiteren Fall kann mindestens einer der drei Kombinationen im dritten Fall auf mehr als zwei Datenpakete bzw. zwei Teile von Datenpaketen angewendet werden.

Besonders zweckmäßig ist es, die Verwendung eines gemeinsamen Generatorpolynoms für die Kanalcodierung und/oder für die Erzeugung der Redundanzinformationen der Nutzdaten in den Paketkerndaten und für die Kanalcodierung und/oder für die Erzeugung der Redundanzinformationen der Nutzdaten im Nutzdatenbereich zu überprüfen. Um zu überprüfen, ob zwei verschiedene Generatorpolynome für die Redundanzinformationen, insbesondere Informationen zur Fehlererkennung, insbesondere Informationen zur zyklischen Redundanzprüfung (CRC), im Kernteil bzw. im Nutzdatenbereich verwendet worden sind, oder ein gemeinsames Generatorpolynom, können die Redundanzinformationen, insbesondere Informationen zur Fehlererkennung, insbesondere Informationen zur zyklischen Redundanzprüfung (CRC), der Nutzdaten im Nutzdatenbereich überprüft werden. Beispielsweise kann zunächst der Teil der Redundanzinformationen, insbesondere Informationen zur Fehlererkennung, insbesondere Informationen zur zyklischen Redundanzprüfung (CRC), der Nutzdaten im Nutzdatenbereich überprüft werden und sofern dieser nicht mittels eines gemeinsamen Generatorpolynoms berechenbar ist, mit einer Überprüfung auf ein eigenes, spezielles Generatorpolynom begonnen werden. Hierfür können vorteilhafterweise die Redundanzinformationen, insbesondere Informationen zur Fehlererkennung, insbesondere Informationen zur zyklischen Redundanzprüfung (CRC), der Nutzdaten im Nutzdatenbereich auf die Verwendung eines eigenen, speziellen Generatorpolynoms überprüft werden. Im Empfänger, wo die Prüfung typischerweise durchführt wird, kann beispielsweise ein Register geführt werden, in dem hinterlegt wird, welcher Sender welche Art von Generatorpolynom verwendet. Entsprechend besteht die Möglichkeit, dass der Empfänger die Prüfungsreihenfolge umstellt, so dass zunächst auf das für den jeweiligen Sender hinterlegte Generatorpolynom geprüft wird. Dadurch entsteht vorteilhafterweise keine wesentliche Erhöhung der Rechenzeit am Empfänger.

Nebengeordnet beansprucht die vorliegende Erfindung außerdem einen Sender zum Übertragen von Nutzdaten innerhalb eines Zeitintervalls T über einen Kommunikationskanal zu einem Empfänger, mit einer Einrichtung zum Erzeugen einer Mehrzahl kanalcodierter Datenpakete aus den Nutzdaten, wobei jedes der kanalcodierten Datenpakete mit Paketkerndaten entsprechend der Paketkennung des jeweiligen kanalcodierten Datenpakets versehen ist, und wobei die Paketkerndaten mit einem Kanalcode höherer Redundanz codiert sind als die Nutzdaten; und einer Einrichtung zum Senden der Mehrzahl der kanalcodierten Datenpakete in dem Zeitintervall T zu dem Empfänger, wobei kennzeichnenderweise die Einrichtung zum Erzeugen einer Mehrzahl kanalcodierter Datenpakete Redundanzinformationen der Nutzdaten, insbesondere Informationen zur Fehlererkennung, insbesondere Informationen zur zyklischen Redundanzprüfung (CRC), und/oder davon abgeleitete Werte, insbesondere von Informationen zur zyklischen Redundanzprüfung (CRC) abgeleiteten Werten, als Paketkennung oder als Teil der Paketkennung in den Paketkerndaten verwendet, und die Redundanzinformationen der Nutzdaten, insbesondere Informationen zur Fehlererkennung, in mindestens zwei Teilen des Datenpakets, insbesondere in zwei nicht benachbarten Teilen, übertragen werden, wobei diese zwei Teile des Datenpakets mit gleicher Coderate der Kanalkodierung codiert sind. Besonders zweckmäßig ist es, wenn die Einrichtung zum Senden ausgebildet ist, um die Mehrzahl der kanalcodierten Datenpakete im Hinblick auf Inhalt und Sendezeitpunkte unabhängig von einem Rückkanal von dem Empfänger zu dem Sender in dem Zeitintervall T zu senden.

Zweckmäßigerweise kann die Einrichtung zum Erzeugen (Encoder) ausgebildet sein, die kanalcodierten Datenpakete mit jeweils unterschiedlichen Kanalcodierungen zu erzeugen. So besteht beispielsweise die Möglichkeit, dass sich die Coderaten $R_n$ mit n = 1, 2, n ... N, mit denen die Nutzdaten in den zugehörigen, codierten Datenpaketen (z. B. mit den punktierten Sendepaketen) codiert sind, von Datenpaket zu Datenpaket unterscheiden können. Ferner ist es möglich, dass auch vorgegebene Gruppen von Datenpaketen (z. B. mit n ungeradzahlig bzw. n geradzahlig) zueinander unterschiedliche Coderaten aufweisen können. Die jeweilige Gruppe kann eine beliebige Auswahl (z. B. einzelne Datenpakete, mehrere aufeinander folgende Datenpakete, etc.) der Datenpakete, die auf zugehörigen Nutzdaten basieren, umfassen. So kann beispielsweise daraus in einem ersten Datenpaket ein Kanalcode der Rate $R_1$ resultieren, während in einem zweiten Datenpaket die codierten Nutzdaten mit einem Kanalcode der Rate $R_2$ codiert übertragen werden (z. B. mit $R_1 = \frac{1}{2}$ und $R_2 = \frac{1}{3}$).

In einer bevorzugten Ausgestaltung kann der Sender mit einem Messgerät, insbesondere einem Heizungs-, Strom- oder Wasserzähler, gekoppelt sein, so dass die Messdaten des Messgeräts dem Sender als Nutzdaten bereitgestellt werden.

Nebengeordnet beansprucht die vorliegende Erfindung zudem einen Empfänger zum Empfangen von Nutzdaten, die innerhalb eines Zeitintervalls T mittels einer Mehrzahl kanalcodierter Datenpakete von einem Sender über einen Kommunikationskanal zu dem Empfänger übertragen werden, wobei jedes der kanalcodierten Datenpakete mit Paketkerndaten entsprechend der Paketkennung des jeweiligen kanalcodierten Datenpakets versehen ist, und wobei die Paketkerndaten mit einem Kanalcode höherer Redundanz codiert sind als die Nutzdaten, mit folgenden Merkmalen: einer Einrichtung zum Empfangen der Mehrzahl der kanalcodierten Datenpakete in dem Zeitintervall T; und einem Decoder, der angepasst ist, um Paketkerndaten eines ersten empfangenen kanalcodierten Datenpakets des Zeitintervalls T zu decodieren und, im Fall eines Scheiterns eines fehlerfreien Decodierens des ersten kanalcodierten Datenpakets, um Paketkerndaten wenigstens eines zweiten empfangenen kanalcodierten Datenpakets des Zeitintervalls T zu decodieren, um ein geeignetes weiteres kanalcodiertes Datenpaket des Zeitintervalls für eine Kombination mit dem ersten kanalcodierten Datenpaket zu ermitteln, um aufgrund der Kombination einen erhöhten Codegewinn für eine Decodierung der Nutzdaten zu erhalten, wobei kennzeichnenderweise der Decoder zum Decodieren eines kanalcodierten Datenpakets die Redundanzinformationen der Nutzdaten, insbesondere Informationen zur Fehlererkennung, insbesondere Informationen zur zyklischen Redundanzprüfung (CRC), und/oder davon abgeleitete Werte, insbesondere von Informationen zur zyklischen Redundanzprüfung (CRC) abgeleiteten Werten, welche als Paketkennung oder als Teil der Paketkennung in den Paketkerndaten dienen und in mindestens zwei Teilen des Datenpakets, insbesondere in zwei nicht benachbarten Teilen, übertragen werden, verwendet werden. Besonders zweckmäßig ist es, wenn der Empfänger keinen Rückkanal zu dem Sender aufweist, um den Sender zu einem erneuten Senden eines kanalcodierten Datenpakets im Fall einer fehlgeschlagenen Decodierung der Nutzdaten zu veranlassen.

Vorteilhafterweise kann der Decoder ausgebildet sein, um durch die Decodierung eines ersten kanalkodierten Datenpakets gewonnene Information als Redundanzinformation zur Decodierung eines zweiten und/oder eines weiteren kanalkodierten Datenpakets zu verwenden, und/oder um einen erhöhten Codegewinn zu erhalten.

Zweckmäßigerweise kann der Decoder ausgebildet sein, um ein kanalkodiertes Datenpaket einer vorgegebenen Gruppe von kanalcodierten Datenpaketen, die auf zugehörigen Nutzdaten basieren, unabhängig von den anderen kanalkodierten Datenpaketen der Gruppe zu decodieren. Ferner kann der Decoder zweckmäßigerweise ausgebildet sein, um zumindest eine vorgegebene Auswahl von Kombinationen der kanalcodierten Datenpakete, die auf zugehörigen Nutzdaten basieren, zu decodieren.

Nebengeordnet beansprucht die vorliegende Erfindung außerdem ein System zum Übertragen von Nutzdaten innerhalb eines Zeitintervalls T von einem Sender über einen Kommunikationskanal zu einem Empfänger mit folgenden Merkmalen: einem Sender gemäß einem der Ansprüche 15 oder 16; und einem Empfänger gemäß einem der Ansprüche 17 bis 19.

Nebengeordnet beansprucht die vorliegende Erfindung zudem ein Computerprogramm zur Durchführung eines Verfahrens gemäß einem der Ansprüche 1 bis 14, wobei das Computerprogramm auf einem Rechner oder Mikrocontroller abläuft, der einem Sender oder einem Empfänger zugeordnet ist.

Beschreibung der Erfindung anhand von Ausführungsbeispielen

Zweckmäßige Ausgestaltungen der vorliegenden Erfindung werden anhand von Zeichnungsfiguren nachstehend näher erläutert. Es zeigen:

Fig. 1    eine stark vereinfachte schematische Darstellung der Bildung kanalkodierter Datenpakete aus den Nutzdaten;

Fig. 2    eine stark vereinfachte schematische Darstellung der Aufteilung kanalkodierter Datenpakete in Paketkerndaten und einen Nutzdatenbereich;

Fig. 3    eine beispielhafte schematische Vorgehensweise zum Erzeugen von kanalkodierten Datenpaketen;

Fig. 4a    eine vereinfachte schematische Darstellung der unterschiedlichen Codierung von Paketkerndaten und der Nutzdaten im Nutzdatenbereich;

Fig. 4b    eine vereinfachte schematische Darstellung der Codierung von Paketkerndaten und der Nutzdaten im Nutzdatenbereich mit der effektiv gleichen Codierung;

Fig. 4c    eine vereinfachte schematische Darstellung der Codierung von Paketkerndaten und der Nutzdaten im Nutzdatenbereich mit einer Mischform verschiedener Codierungen;

Fig. 5    eine vereinfachte schematische Darstellung eine Bitvergleichs verschiedener Teile von kanalkodierten Datenpaketen;

Fig. 6a    eine vereinfachte schematische Darstellung der Erzeugung verschiedener Redundanzinformationen aus den gleichen Nutzdaten durch unterschiedliche Polynome;

Fig. 6b    eine vereinfachte schematische Darstellung der Erzeugung von Redundanzinformationen aus den Nutzdaten durch die Verwendung eines gemeinsamen Polynoms; und

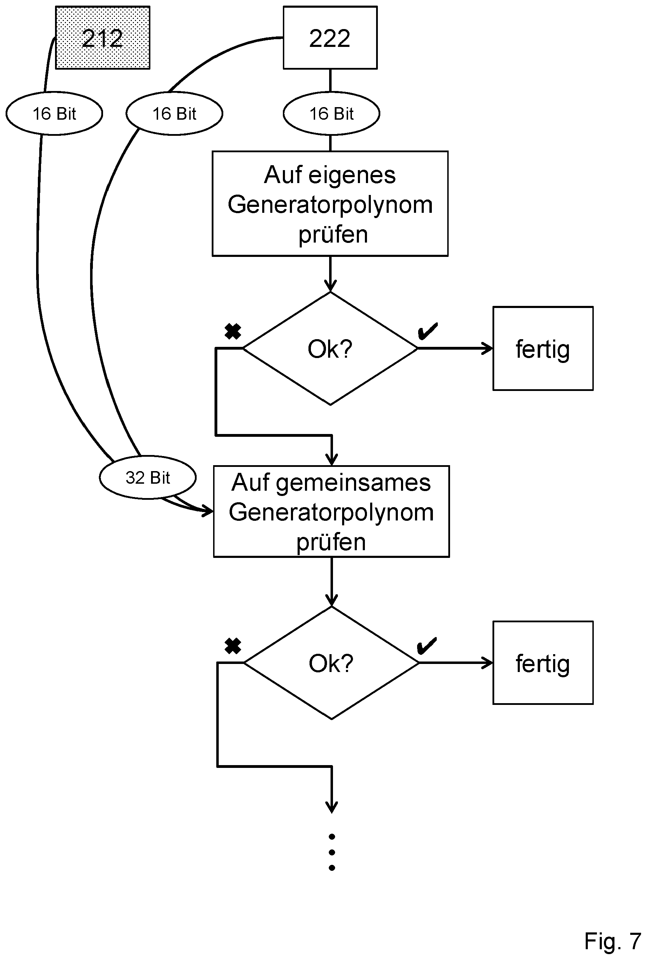

Fig. 7    eine vereinfachte schematische Darstellung der Prüfung des Generatorpolynoms von Redundanzinformationen.

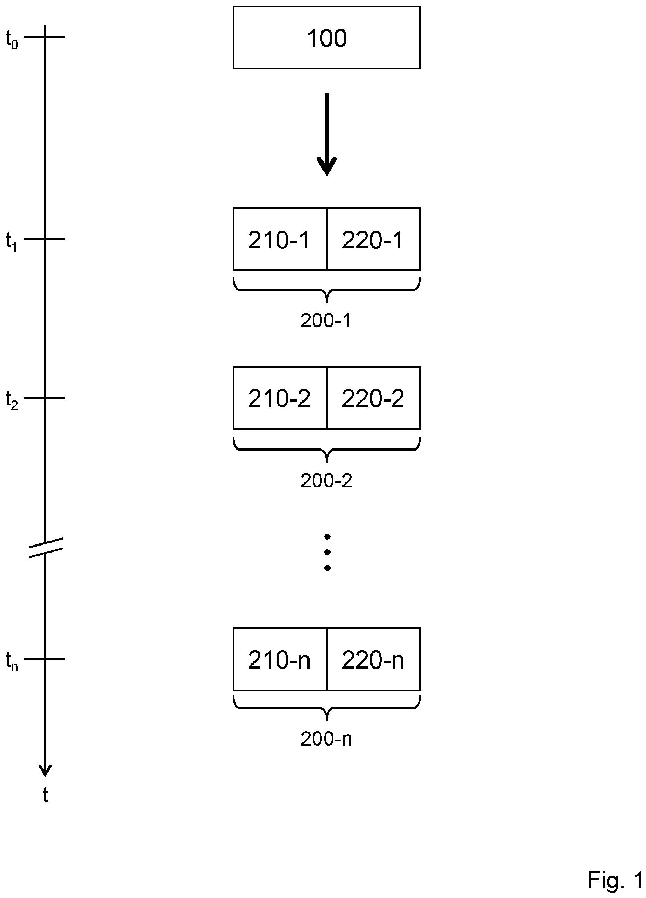

Fig. 1 zeigt eine stark vereinfachte schematische Darstellung der Bildung kanalkodierter Datenpakete 200-1 bis 200-n aus den Nutzdaten 100. Die kanalkodierten Datenpakete 200-1 bis 200-n werden zu unterschiedlichen Zeiten $t_1$ bis $t_n$ innerhalb eines Zeitintervalls T über einen Kommunikationskanal zu einem Empfänger 400 übertragen. Die kanalkodierten Datenpakete 200-1 bis 200-n umfassen dabei Paketkerndaten 200-1 bis 200-n sowie einen Nutzdatenbereich 220-1 bis 220-n, in dem die Nutzdaten 100 übertragen werden.

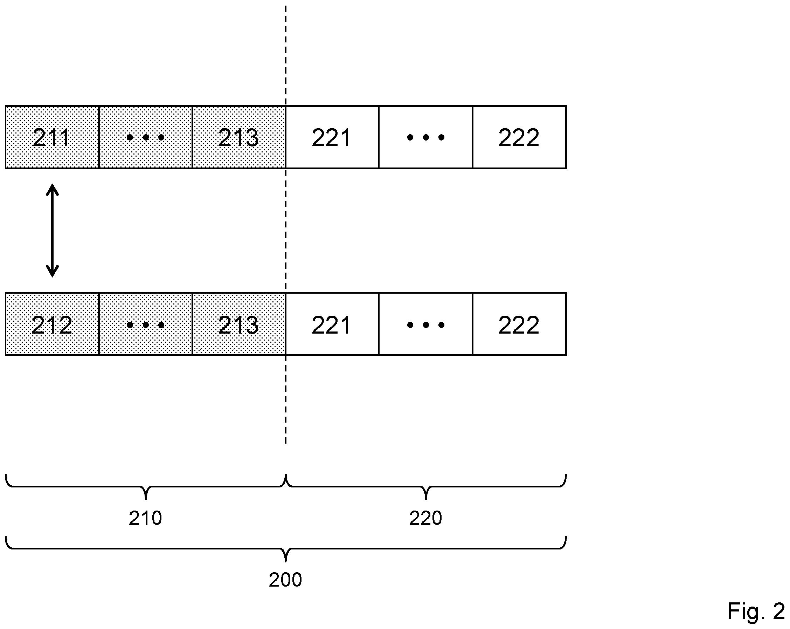

In Fig. 2 ist ein Datenpaket 200 mit seinem Aufbau exemplarisch dargestellt. Das Datenpaket 200 lässt sich in einen Bereich der Paketkerndaten 210 und einen Nutzdatenbereich 220 aufteilen. Die Paketkerndaten 210 umfassen für gewöhnlich eine Paketkennung (ID) 211 sowie Redundanzinformationen der Paketkerndaten 213. Es ist allerdings nicht notwendig, als Paketkennung 211 eine Kennung in der Art zu verwenden, dass der entsprechende Teilnehmer bzw. Sender 300 identifiziert werden kann. Für ein Code-Combining mehrerer Datenpakete 200-1 bis 200-n ist es ausreichend, eine Information in den Paketkerndaten 210 als Paketkennung 211 zu verwenden, die in allen Paketkerndaten 210-1 bis 210-n der Mehrzahl von Datenpaketen 200-1 bis 200-n gleich ist. Als Paketkennung 211 können somit auch die Redundanzinformationen der Nutzdaten 102 oder ein Teil der Redundanzinformationen der Nutzdaten 102 verwendet werden.

Der Nutzdatenbereich 220 umfasst die Nutzdaten 100 in Form von kanalkodierten Nutzdaten 221 und Redundanzinformationen der Nutzdaten 102. Die Redundanzinformationen der Nutzdaten im Kernteil 212 können mit den Redundanzinformationen der Nutzdaten im Nutzdatenbereich 222 identisch, teilweise identisch oder nicht identisch sein.

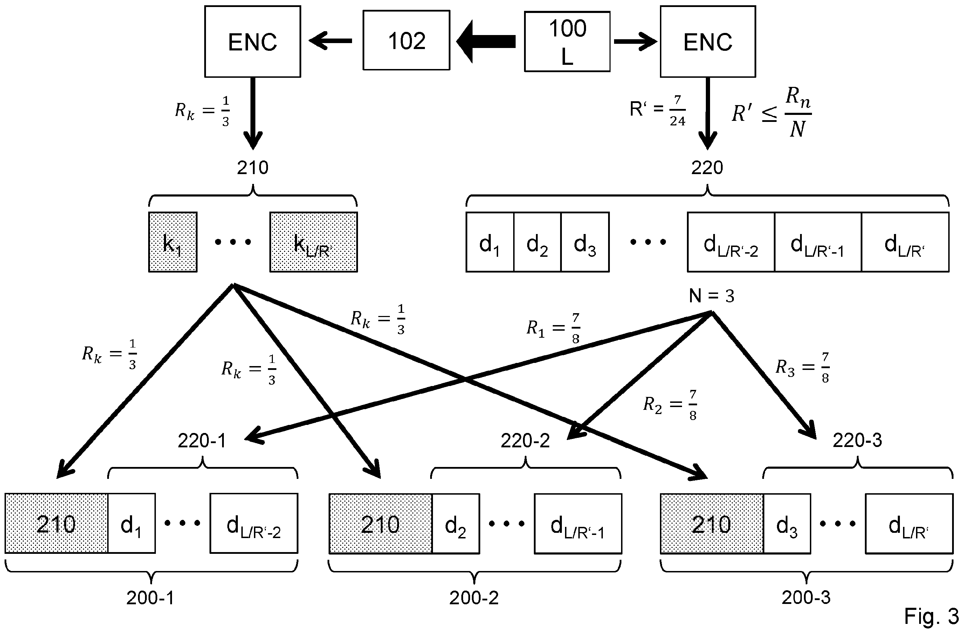

Eine beispielhafte schematische Vorgehensweise zum Erzeugen von kanalkodierten Datenpaketen 200-1 bis 200-3 ist in Fig. 3 gezeigt. Ausgehend von den Nutzdaten 100 werden die Paketkerndaten 210 und die Nutzdatenbereiche 220-1 bis 220-3 der Datenpakete 200-1 bis 200-3 erzeugt. Für die Nutzdatenbereiche 220-1 bis 220-3 werden die Nutzdaten 100 der Länge L im Encoder ENC encodiert mit einer effektiven Coderate

$$R' \leq \frac{R_n}{N}$$

, wobei $R_n$ die Coderate der einzelnen Nutzdatenbereiche 220-n der Datenpakete 200-n bezeichnet und N die Anzahl der Datenpakete 200-n. Die Nutzdaten 100 können die Informationen zur Fehlererkennung, insbesondere Informationen zur zyklischen Redundanzprüfung (CRC), umfassen und werden in der beispielhaften Ausgestaltung mit einer effektiven Coderate von $R' = \frac{7}{24}$ encodiert. Die kanalkodierten Nutzdaten 221 weisen im Nutzdatenbereich 220 somit eine Länge von $\frac{L}{R'}$, auf. Sofern die Nutzdaten 100 die Redundanzinformationen der Nutzdaten 102, also beispielsweise CRC-Bits mit einer beispielhaften Länge von 2, umfassen, weisen die kanalkodierten Nutzdaten 221 damit eine Länge von $\frac{(L+2)}{R'}$ auf. Diese werden auf $N = 3$ Datenpakete 200-1 bis 200-3 aufgeteilt, so dass der jeweilige Nutzdatenbereich eine Coderate von $R_n = R_1 = R_2 = R_3 = \frac{7}{8}$ aufweist. Jedes Datenpaket 200-n kann auch eine individuelle Coderate aufweisen, die sich von den Coderaten der anderen Datenpakete 200-n unterscheidet. Dann ist $R_{nx} \neq R_{ny}$.

Die Paketkerndaten 210 werden für gewöhnlich mit einer Coderate höherer Redundanz als die Nutzdaten 100 codiert. In Fig. 3 ist die Coderate der Paketkerndaten 210 beispielsweise $R_k = \frac{1}{3}$. Die Paketkerndaten 210 werden benötigt, um die Nutzdaten 100 von mehreren Datenpaketen 200-1 bis 200-3 zu kombinieren. Aus diesem Grund sind die Paketkerndaten 210 durch eine bessere Kanalcodierung bzw. durch eine Kanalcodierung mit höherer Redundanz und entsprechend kleinerer Coderate R geschützt. In jeden Paketkerndaten 210 eines jeden Datenpakets 200-1 bis 200-3 werden die gleichen kanalcodierten Bits des Kerns übertragen. Die kanalcodierten Bits der Nutzdaten 100 werden hingegeben nicht am Stück übertragen, sondern sind auf die Datenpakete 200-1 bis 200-3 aufgeteilt, so dass mit jedem zusätzlich empfangenen Datenpaket 200-1 bis 200-3 weitere unbekannte kanalcodierte Bits im Nutzdatenbereich 220-1 bis 220-3 der Datenpakete 200-1 bis 200-3 hinzukommen. Die Redundanzinformationen der Nutzdaten 102 sind somit in den Paketkerndaten 210, wo sie als Paketkennung verwendet werden, und im Nutzdatenbereich 220 unterschiedlich codiert. Die schlechtere Kodierung bzw. die Kodierung mit geringerer Redundanz bestimmt die Performance bzw. die Reichweite der Datenübertragung.

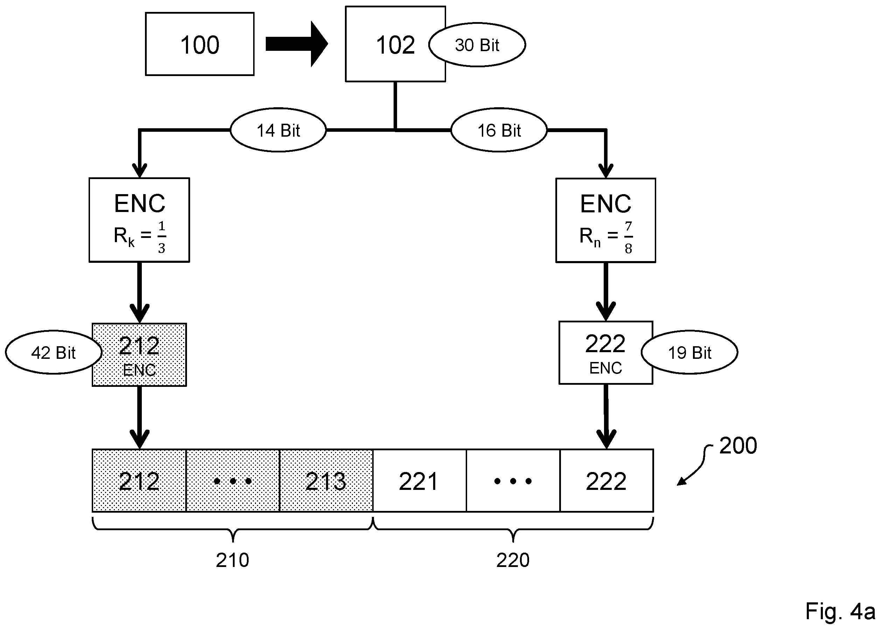

In Fig. 4a ist der Einfluss unterschiedlicher Kodierungen bzw. unterschiedlicher Coderaten R auf die Redundanz-Bits bzw. CRC-Bits gezeigt. Die Redundanzinformationen der Nutzdaten 102 umfassen beispielsweise 30 Bits. Von diesen 30 Bits werden 14 Bits auf die Paketkerndaten 210 und 16 Bits auf den Nutzdatenbereich 220 von Datenpaketen 200 aufgeteilt. Für die Paketkerndaten 210 werden die Redundanzinformationen der Nutzdaten 102 durch einen Encoder ENC mit der Coderate $R_k = \frac{1}{3}$ kodiert, so dass die kodierten Redundanzinformationen der Nutzdaten im Kernteil 212 eine Länge von 42 Bit aufweisen. Für den Nutzdatenbereich 220 werden die Redundanzinformationen der Nutzdaten 102 durch einen Encoder ENC mit einer Coderate $R_n = \frac{7}{8}$ kodiert. Die Redundanzinformationen der Nutzdaten im Nutzdatenbereich 222 weisen damit eine Länge von 19 Bit auf. Das Beispiel in Fig. 4a macht deutlich, dass die Redundanzinformationen der Nutzdaten 102 in den Paketkerndaten 210 stärker geschützt sind bzw. eine höhere Redundanz aufweisen, als die Redundanzinformationen der Nutzdaten 102, welche im Nutzdatenbereich 220 eingepflegt werden.

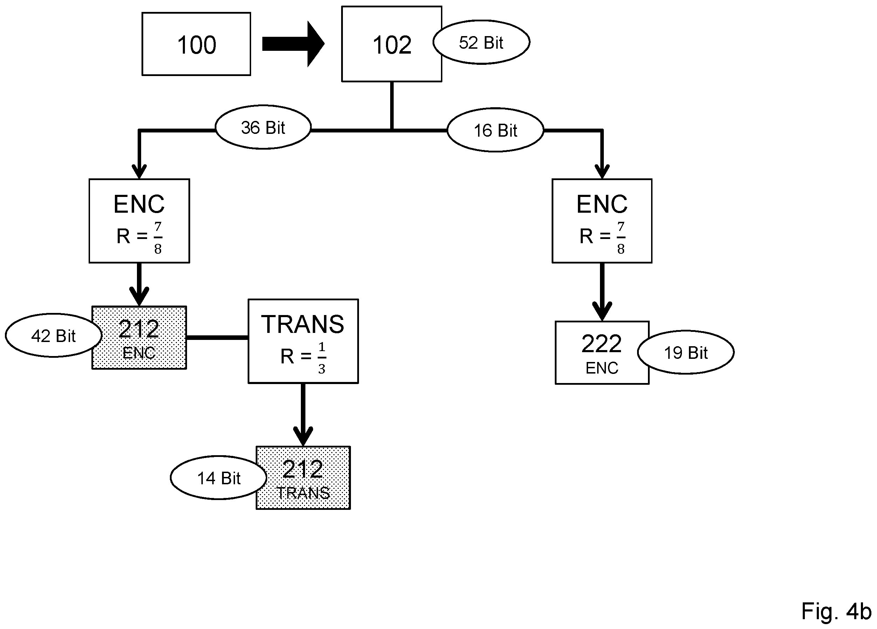

Eine Möglichkeit, die Kodierung der Redundanzinformationen der Nutzdaten im Kernteil 212 und der Redundanzinformationen der Nutzdaten im Nutzdatenbereich 222 anzugleichen ist in Fig. 4b gezeigt. Der geringere Kanalkodierungsschutz der Redundanzinformationen der Nutzdaten im Kernteil 212 bietet den Vorteil, dass Bits zur Übertragung verwendet werden können, also mehr Daten übertragen werden können. Beispielsweise können somit mehr Redundanzinformationen der Nutzdaten 102, also mehr Nutzdaten-CRC-Bits übertragen werden, oder die zusätzlichen Übertragungskapazitäten für andere Zwecke verwendet werden. In Fig. 4b werden die Redundanzinformationen der Nutzdaten 102 bzw. die Nutzdaten CRC-Bits, welche für die Paketkerndaten 210 vorgesehen sind, mittels einem Encoder ENC mit einer Coderate, die der des Encoders ENC für den Nutzdatenbereich 220 entspricht, hier z. B. $R_k = R_n = \frac{7}{8}$, kodiert. Beispielsweise sind 36 Bits für die Paketkerndaten 210 vorgesehen, so dass diese nach der Kodierung 42 Bits entsprechen. Damit die Redundanzinformationen der Paketkerndaten 213 bzw. die Kerndaten-CRC gebildet werden können und die gesamten Kerndaten mit einer Coderate von $R = \frac{1}{3}$ dekodiert werden können, werden die 42 CRC-Bits hierfür transformiert. Für die Transformation können die 42 CRC-Bits durch einen Faltungscode Decoder mit einer Coderate von $R = \frac{1}{3}$ dekodiert werden. Dadurch werden transformierte Redundanzinformationen der Nutzdaten im Kernteil 212 mit einer Länge von 14 Bits erhalten.

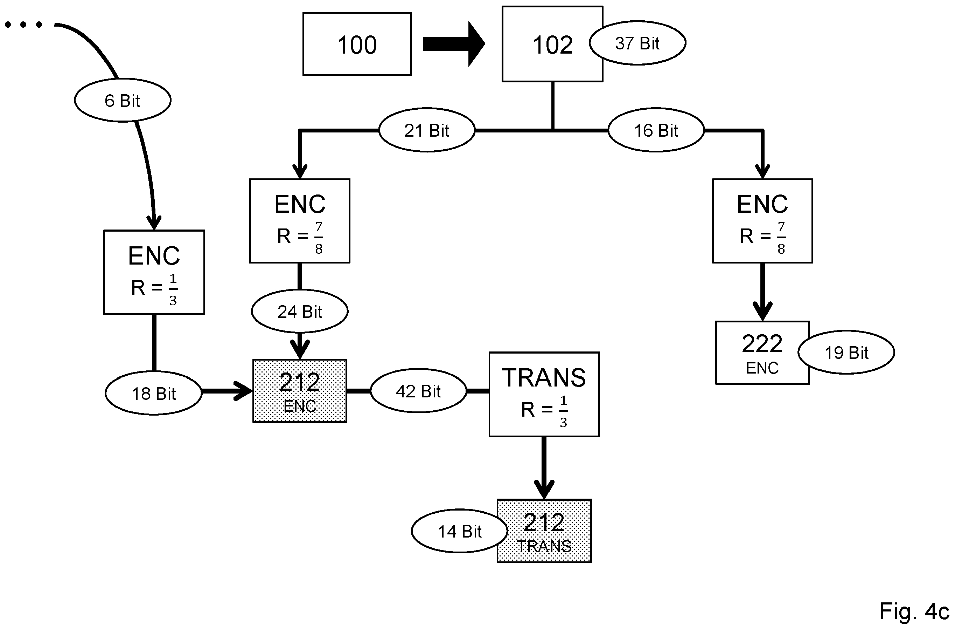

Eine weitere alternative Möglichkeit ist in Fig. 4c gezeigt. In dieser Ausgestaltung werden nicht alle zusätzlichen Bits, die durch die effizientere Kodierung entstanden sind, wie in Fig. 4b gezeigt, für Redundanzinformationen bzw. CRC verwendet. Es ist ferner denkbar, dass ein Teil dieser zusätzlichen Bits für andere Kontroll-Informationen verwendet werden können. Das Beispiel in Fig. 4c zeigt eine Verwendung für Redundanzinformationen bzw. CRC als Mischform. Dabei werden ein Teil der CRC Bits in den Kerndaten mit einer höheren Coderate kodiert und ein anderer Teil mit einer effizienteren Kodierung, also einer Kodierung mit einer geringeren Coderate. In Fig. 4c werden beispielsweise 37 CRC Bits als Redundanzinformation verwendet. Von diesen 37 CRC Bits können 16 Bits im Nutzdatenbereich untergebracht werden. Diese werden wiederum mit einer Coderate von

$$R = \frac{7}{8}$$ kodiert und die entsprechenden 19 Bits in den Redundanzinformationen der Nutzdaten im Nutzdatenbereich 222 untergebracht. Die anderen 21 Bits der 37 CRC Bits werden in den Paketkerndaten 210 untergebracht. Hierfür werden diese 21 Bits mit einer Coderate von $$R = \frac{7}{8}$$ kodiert. Die entsprechenden 24 Bits bilden einen Teil der encodierten Redundanzinformationen der Nutzdaten im Kernteil 212. Die encodierten Redundanzinformationen der Nutzdaten im Kernteil 212 umfassen 42 Bits, so dass die übrigen 18 Bits mit 6 Bits aufgefüllt werden, die mit einer Coderate von $$R = \frac{1}{3}$$ kodiert worden sind. Dies ergibt in Summe 42 Bits mit den unterschiedlichen Coderaten $$R = \frac{7}{8}$$ bzw. $$R = \frac{1}{3}$$ . Für die Transformation können die 42 CRC-Bits, wie in Fig. 4b, durch einen Faltungscode Decoder mit einer Coderate von $$R = \frac{1}{3}$$ dekodiert werden. Dadurch werden transformierte Redundanzinformationen der Nutzdaten im Kernteil 212 mit einer Länge von 14 Bits erhalten.

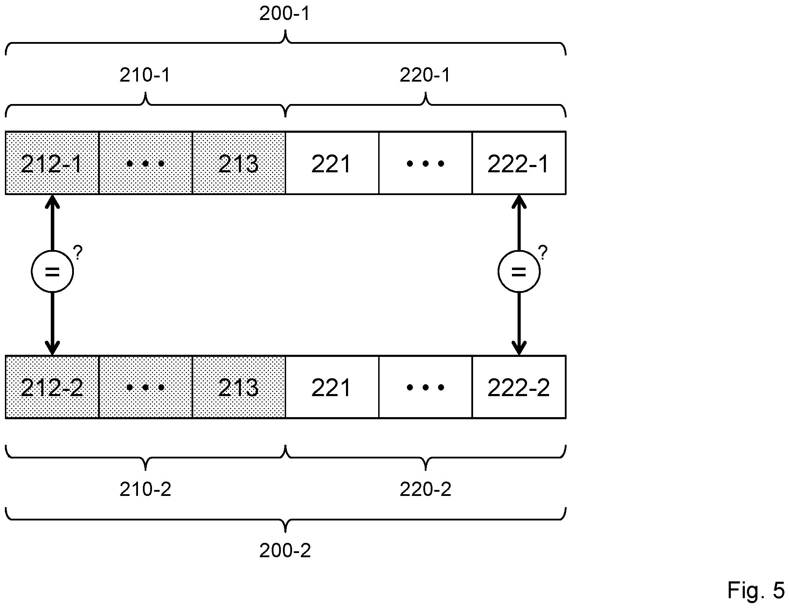

In Fig. 5 ist die Verwendung des zeitlichen Aspekts für eine false-positive-Reduktion gezeigt. Dabei wird ein erstes empfangenes Datenpaket 200-1 auf gültige Redundanzinformationen bzw. auf gültige CRC geprüft. Sofern die Gültigkeit festgestellt worden ist, wird vor der Weiterverarbeitung der Daten mindestens der Empfang eines weiteren zugehörigen Datenpakets 200-2 abgewartet. Die Redundanzinformationen der Nutzdaten im Kernteil 212-1 und 212-2 sowie die Redundanzinformationen der Nutzdaten im Nutzdatenbereich 222-1 und 222-2 werden jeweils miteinander verglichen. Sofern die Bits nicht identisch sind, also nicht 1 zu 1 übereinstimmen, wird das Datenpaket 200-1 bzw. das Telegramm mit der fälschlicherweise als korrekt angenommenen Redundanzinformation bzw. CRC verworfen. Bei der Überprüfung können mehrere Kombinationen ausgewertet werden. Um das Datenpaket 200 als gültig zu behandeln, kann in einer ersten Ausgestaltung die Gültigkeit der Redundanzinformationen der Nutzdaten im Kernteil 212-1 und die Redundanzinformationen der Nutzdaten im Nutzdatenbereich 222-1 ausreichend sein. In einer zweiten Ausgestaltung ist es ausreichend, um ein Datenpaket 200 als gültig zu behandeln, wenn die Redundanzinformationen der Nutzdaten im Kernteil 212-1 und die Redundanzinformationen der Nutzdaten im Nutzdatenbereich 222-1 gültig sind sowie die Redundanzinformationen der Nutzdaten im Kernteil 212-1 und 212-2 von zwei Datenpaketen 200-1 und 200-2 übereinstimmen. In einer dritten Ausgestaltung ist es ausreichend, um ein Datenpaket 200 als gültig zu behandeln, wenn die Redundanzinformationen der Nutzdaten im Kernteil 212-1 und die Redundanzinformationen der Nutzdaten im Nutzdatenbereich 222-1 gültig sind, die Redundanzinformationen der Nutzdaten im Kernteil 212-1 und 212-2 von zwei Datenpaketen 200-1 und 200-2 übereinstimmen und die Redundanzinformationen der Nutzdaten im Nutzdatenbereich 222-1 und 222-2 übereinstimmen. In einer weiteren Ausgestaltung wird mindestens eines der drei Kriterien in der dritten Ausgestaltung auf mehr als zwei Datenpakete 200 bzw. zwei Teile von Datenpaketen 200 angewendet. Weiterhin kann bei dem Bitvergleich auch der zeitliche Abstand, der durch die Redundanzinformationen der Nutzdaten im Kernteil 212-1 bzw. 212-2 definiert ist, auf Richtigkeit überprüft werden.

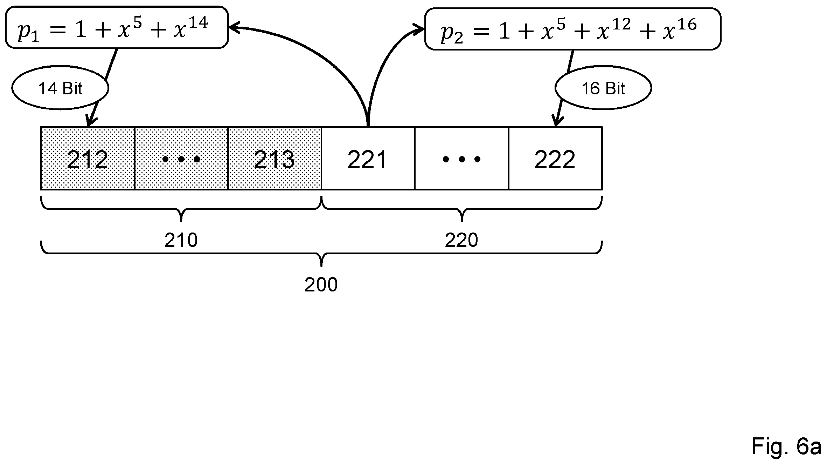

Die Erzeugung der CRC-Werte als Redundanzinformationen beruht auf Polynomdivision. In Fig. 6a sind zwei unterschiedliche Generatorpolynome $p_1$ und $p_2$ zur Erzeugung der 14- bzw. 16-Bit CRC-Werte im Kernteil 212 und im Nutzdatenteil 222. Hierbei werden für gewöhnlich die zu übertragenden Bits als binäres Polynom betrachtet. Die Bitfolge der Coderepräsentation der Daten wird durch ein vorher festgelegtes Generatorpolynom (das sog. CRC-Polynom) Modulo mod(2) geteilt, wobei der Rest den CRC-Wert darstellt. Um einen Binärcode von 14 bzw. 16 Bits den CRC-Wert zu berechnen, wird jeweils ein Generatorpolynom mindestens vom Grad 14 bzw. 16 benötigt. Das Generatorpolynom $p_1$ ist entsprechend vom Grad 14 und das Generatorpolynom $p_2$ ist vom Grad 16. Es werden somit zwei unterschiedliche Polynome verwendet für die Redundanzinformationen der Nutzdaten im Nutzdatenbereich (Nutzdaten CRC) 222 und die Redundanzinformationen der Nutzdaten im Kernteil (Nutzdaten CRC) 212. Alle Bündelfehler (engl. Burst) mit einer Länge kleiner oder gleich des Grads des CRC-Polynoms werden erkannt. Somit können maximal Burst Fehler mit einer Länge des Generatorpolynoms mit höherem Grad detektiert werden.

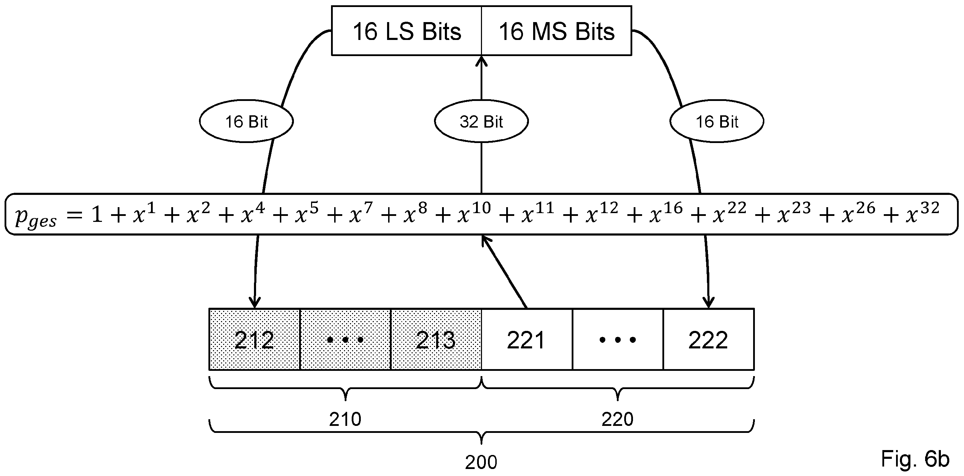

Aus einem Generatorpolynom mit einem höheren Grad können alle Teil-Generatorpolynome mit geringerem Grad generiert werden. In Fig. 6b wird die Verwendung eines Generatorpolynoms $p_{ges}$ mit Grad 32 gezeigt. Aus den Nutzdaten 221 werden Redundanzinformationen bzw. ein CRC-Wert mit der Länge 32 Bit erzeugt, indem als Generatorpolynom $p_{ges} = 1 + x^1 + x^2 + x^4 + x^5 + x^7 + x^8 + x^{10} + x^{11} + x^{12} + x^{16} + x^{22} + x^{23} + x^{26} + x^{32}$ mit Grad 32 verwendet wird. Dieser CRC-Wert mit Länge 32 Bit wird in zwei Teile aufgeteilt. Der erste Teil umfasst die 16 geringwertigsten (LS) Bits (engl. least significant bit), der zweite Teil umfasst die 16 hochwertigsten (MS) Bits (engl. most significant bit). Der erste Teil wird im Kernteil als Paketkennung verwendet und stellt somit die Redundanzinformationen der Nutzdaten im Kernteil 212 dar. Der zweite Teil stellt die Redundanzinformationen der Nutzdaten im Nutzdatenbereich 222 dar. Es besteht ferner die Möglichkeit, Generatorpolynome höheren Grades, z. B. mit Grad 60, zu verwenden. Dadurch könnten mehr Bits, z. B. 60 Bits, als Redundanzinformationen genutzt werden.

Um zu überprüfen, ob zwei verschiedene Generatorpolynome für die Redundanzinformationen im Kernteil bzw. im Nutzdatenbereich verwendet worden sind, oder ein gemeinsames Generatorpolynom, werden der 16 Bit CRC-Wert am Ende der Nutzdaten, also die Redundanzinformationen der Nutzdaten im Nutzdatenbereich 222 (Nutzdaten CRC), überprüft. Hierfür werden diese 16 Bits zunächst auf ein eigenes Generatorpolynom, welches typischerweise vom Grad 16 ist, überprüft. Sofern diese erste Prüfung keine valide CRC ergibt, werden diese 16 Bits aus den Redundanzinformationen der Nutzdaten im Nutzdatenbereich 222 (Nutzdaten CRC) zusammen mit den Redundanzinformationen der Nutzdaten im Kernteil 212 (Nutzdaten CRC) überprüft. Sofern der CRC-Wert 32 Bits umfasst, wie in der Ausgestaltung in Fig. 6b, werden diese 32 Bits auf ein gemeinsames Generatorpolynom überprüft, welches typischerweise vom Grad 32 ist. Sofern diese zweite Prüfung keine valide CRC liefert, können weitere Prüfungsschritte nachgeschaltet werden. Der Empfänger 400, welcher die Prüfung typischerweise durchführt, kann einen Counter umfassen, in dem hinterlegt wird, welcher Sender 300 welche Art von Generatorpolynom verwendet. Entsprechend besteht die Möglichkeit, dass der Empfänger 400 die Prüfungsreihenfolge umstellt, so dass zunächst auf das für den jeweiligen Sender 300 hinterlegte Generatorpolynom geprüft wird. Dadurch entsteht keine wesentliche Erhöhung der Rechenzeit am Empfänger 400.

BEZUGSZEICHENLISTE

| 100 | Nutzdaten |
| 102 | Redundanzinformationen der Nutzdaten |
| 200 | Datenpaket |
| 210 | Paketkerndaten |
| 211 | Paketkennung |
| 212 | Redundanzinformationen der Nutzdaten im Kernteil |
| 213 | Redundanzinformationen der Paketkerndaten |
| 220 | Nutzdatenbereich |
| 221 | kanalkodierte Nutzdaten |
| 222 | Redundanzinformationen der Nutzdaten im Nutzdatenbereich |
| 300 | Sender |
| 400 | Empfänger |

| CRC | zyklische Redundanzprüfung |
| ENC | Encoder |
| DEC | Decoder |
| TRANS | Transformation |
| $R_x$ | Coderate |
| R' | effektive Coderate |
| m | Anzahl Telegramme |
| n | Anzahl Datenpakete |

**Patentansprüche**

1. Verfahren zum Übertragen von Nutzdaten (100-m) innerhalb eines Zeitintervalls (T) über einen Kommunikationskanal zu einem Empfänger (400), mit folgenden Schritten:

   Erzeugen einer Mehrzahl kanalcodierter Datenpakete (200-n) aus den Nutzdaten (100-m), wobei jedes der kanalcodierten Datenpakete (200-n) mit Paketkerndaten (210-n) entsprechend der Paketkennung des jeweiligen kanalcodierten Datenpakets versehen ist,
   wobei Redundanzinformationen (102-n) der Nutzdaten (100-m), insbesondere Informationen zur Fehlererkennung, insbesondere Informationen zur zyklischen Redundanzprüfung, CRC, und/oder davon abgeleitete Werte, insbesondere von Informationen zur zyklischen Redundanzprüfung, CRC, abgeleiteten Werten, als Paketkennung oder als Teil der Paketkennung in den Paketkerndaten (210-n) verwendet werden und
   die Redundanzinformationen (102-n) der Nutzdaten (100-m), insbesondere Informationen zur Fehlererkennung, in mindestens zwei Teilen des Datenpakets (220-n), insbesondere in zwei nicht benachbarten Teilen, übertragen werden, wobei diese zwei Teile des Datenpakets (220-n) mit gleicher Coderate der Kanalkodierung codiert sind.

2. Verfahren nach Anspruch 1, **dadurch gekennzeichnet, dass** ein erster Teil der Redundanzinformationen (102-n) der Nutzdaten (100-m) als Paketkennung in den Paketkerndaten (210-n) verwendet wird und ein zweiter Teil der Redundanzinformationen (102-n) der Nutzdaten (100-m) im Nutzdatenbereich (220-n) übertragen wird.

3. Verfahren nach einem der Ansprüche 1 oder 2, **dadurch gekennzeichnet, dass** Redundanzinformationen (213-n) der Paketkerndaten (210-n) mit den Paketkerndaten (210-n) übertragen werden.

4. Verfahren nach einem der vorherigen Ansprüche, **dadurch gekennzeichnet, dass** die Mehrzahl der kanalcodierten Datenpakete (200-n) in dem Zeitintervall (T) zu dem Empfänger (400) gesendet werden, wobei das Senden der Mehrzahl der kanalcodierten Datenpakete (200-n) im Hinblick auf Inhalt und Sendezeitpunkte unabhängig von einem Rückkanal von dem Empfänger (400) zu dem Sender (300) in dem Zeitintervall (T) erfolgt.

5. Verfahren nach einem der vorherigen Ansprüche, **dadurch gekennzeichnet, dass** die kanalcodierten Datenpakete (200-n) mittels eines Faltungscodes und eines Punktierungsschemas aus den Nutzdaten (100) erzeugt werden, so dass jedes kanalcodierte Datenpaket (200-n) einer vorgegebenen Gruppe von kanalcodierten Datenpaketen (200-n), die auf zugehörigen Nutzdaten (100) basieren, unabhängig von den anderen kanalcodierten Datenpaketen (200-n) der Gruppe decodierbar ist, wobei insbesondere vorgesehen ist, dass mindestens eine vorgegebene Auswahl von Kombinationen der kanalcodierten Datenpakete (200-n), die auf den zugehörigen Nutzdaten (100) basieren, decodierbar ist.

6. Verfahren nach einem der vorherigen Ansprüche, **dadurch gekennzeichnet, dass** es sich bei den Redundanzinformationen (102-n) der Nutzdaten (100-m) um Informationen zur zyklischen Redundanzprüfung, CRC, insbesondere in Form von angefügten CRC-Werten, handelt.

7. Verfahren nach einem der Ansprüche 2 bis 6, **dadurch gekennzeichnet, dass** mindestens ein Teil der Redundanzinformationen (102-n) der Nutzdaten (100-m), insbesondere die CRC-Daten, in den Paketkerndaten (210-n) effektiv mit der gleichen Coderate der Kanalkodierung codiert ist wie die Redundanzinformationen (102-n) der Nutzdaten (100-m) im Nutzdatenbereich (220-n), wobei insbesondere vorgesehen ist, dass mindestens ein erster Teil der Paketkerndaten (210-n) mit einem Kanalcode höherer Redundanz codiert ist als die kanalkodierten Nutzdaten (221-n) in einem Nutzdatenbereich (220-n), und mindestens ein zweiter Teil der Paketkerndaten (210-n) mit einem Kanalcode gleicher Redundanz codiert ist wie die kanalkodierten Nutzdaten (221-n) im Nutzdatenbereich (220-n), wobei der erste Teil der Paketkerndaten (210-n), der mit einem Kanalcode höherer Redundanz als die kanalkodierten Nutzdaten (221-n) im Nutzdatenbereich (220-n) codiert ist, bevorzugt als Paketkennung in den Paketkerndaten (210-n) verwendet wird.

8. Verfahren nach Anspruch 7, **dadurch gekennzeichnet, dass** die Redundanzinformationen (102-n) der Nutzdaten (100-m), insbesondere die CRC-Daten, für die Übertragung in den Paketkerndaten (210-n) vorbereitet werden:

Kodierung der Redundanzinformationen (102-n) der Nutzdaten (100-m), insbesondere die CRC-Daten, mit dem Kanalcode der Nutzdaten (100);
Transformation der mit dem Kanalcode der Nutzdaten (100) codierten Redundanzinformationen (102-n) der Nutzdaten (100-m), um anschließend mit dem Kanalcode der Paketkerndaten (210-n) codiert zu werden.

9. Verfahren nach einem der Ansprüche 2 bis 6, **dadurch gekennzeichnet, dass** für die Kanalcodierung der Redundanzinformationen (102-n), insbesondere der CRC-Daten, der Nutzdaten (100-m) in den Paketkerndaten (210-n) und für die Kanalcodierung der Redundanzinformationen (102-n), insbesondere der CRC-Daten, der Nutzdaten (100-m) im Nutzdatenbereich (220-n) ein gemeinsames Generatorpolynom verwendet wird, wobei insbesondere vorgesehen ist, dass aus einem Generatorpolynom mit einem höheren Grad alle Teil-Generatorpolynome mit geringerem Grad generiert werden, wobei für die Kanalcodierung und/oder für die Erzeugung der Redundanzinformationen (102-n) der Nutzdaten (100-m) in den Paketkerndaten (210-n) ein Teil-Generatorpolynom verwendet wird.

10. Verfahren nach einem der Ansprüche 2 bis 6, **dadurch gekennzeichnet,**

**dass** für die Erzeugung der Redundanzinformationen (102-n), insbesondere Informationen zur Fehlererkennung, insbesondere Informationen zur zyklischen Redundanzprüfung, CRC, der Nutzdaten (100-m) in den Paketkerndaten (210-n) und für die Erzeugung der Redundanzinformationen (102-n), insbesondere Informationen zur Fehlererkennung, insbesondere Informationen zur zyklischen Redundanzprüfung, CRC, der Nutzdaten (100-m) im Nutzdatenbereich (220-n) ein gemeinsames Generatorpolynom verwendet wird, wobei insbesondere vorgesehen ist, dass aus einem Generatorpolynom mit einem höheren Grad alle Teil-Generatorpolynome mit geringerem Grad generiert werden, wobei für die Kanalcodierung und/oder für die Erzeugung der Redundanzinformationen (102-n) der Nutzdaten (100-m) in den Paketkerndaten (210-n) ein Teil-Generatorpolynom verwendet wird.

11. Verfahren zum Empfangen von Nutzdaten (100-m) mit folgenden Merkmalen:

Empfangen einer Mehrzahl kanalcodierter Datenpakete (200-n) in dem Zeitintervall (T);
Decodieren von Paketkerndaten (210-1) eines ersten kanalcodierten Datenpakets (200-1) des Zeitintervalls (T); und
im Fall eines Scheiterns eines Decodierens des ersten kanalcodierten Datenpakets (200-1), Decodieren von Paketkerndaten (210-2) mindestens eines zweiten kanalcodierten Datenpakets (200-2) des Zeitintervalls (T), um ein geeignetes weiteres kanalcodiertes Datenpaket des Zeitintervalls für eine Kombination mit dem ersten kanalcodierten Datenpaket zu ermitteln, um aufgrund der Kombination einen erhöhten Codegewinn für eine Decodierung der Nutzdaten zu erhalten,

wobei die Nutzdaten (100-m) über einen Kommunikationskanal übertragen werden, und

zum Decodieren eines kanalcodierten Datenpakets (200-n) die Redundanzinformationen (102-n) der Nutzdaten (100-m), insbesondere Informationen zur Fehlererkennung, insbesondere Informationen zur zyklischen Redundanzprüfung, CRC, und/oder davon abgeleitete Werte, insbesondere von Informationen zur zyklischen Redundanzprüfung, CRC, abgeleiteten Werten, welche als Paketkennung oder als Teil der Paketkennung in den Paketkerndaten (210-n) dienen und in mindestens zwei Teilen des Datenpakets (220-n), insbesondere in zwei nicht benachbarten Teilen, übertragen werden, verwendet werden.

12. Verfahren nach Anspruch 11, **dadurch gekennzeichnet, dass** ein kanalcodiertes Datenpaket (200-n) einer vorgegebenen Gruppe von kanalcodierten Datenpaketen (200-n), die auf zugehörigen Nutzdaten (100) basieren, unabhängig von den anderen kanalcodierten Datenpaketen (200-n) der Gruppe decodiert wird, oder dass eine vorgegebene Auswahl von Kombinationen der kanalcodierten Datenpakete (200-n), die auf zugehörigen Nutzdaten (100) basieren, decodiert wird.

13. Verfahren nach einem der Ansprüche 11 oder 12, **dadurch gekennzeichnet, dass** zur Überprüfung der Decodierung eines kanalcodierten Datenpakets (200-1) ein Bitvergleich der Redundanzinformationen (102-1, 102-2) der Nutzdaten (100-m) mit mindestens einem zweiten kanalcodierten Datenpaket (200-2) des Zeitintervalls (T) durchgeführt wird, wobei insbesondere vorgesehen ist, dass ein Bitvergleich der Redundanzinformationen (102-1, 102-2) der Nutzdaten (100-m) in den jeweiligen Paketkerndaten (210-1, 210-2) und/oder ein Bitvergleich der Redundanzinformationen (102-1, 102-2) der Nutzdaten (100-m) in den jeweiligen Nutzdatenbereichen (220-1, 220-2) durchgeführt wird.

14. Verfahren nach einem der vorherigen Ansprüche 11 bis 13, **dadurch gekennzeichnet, dass** die Verwendung eines gemeinsamen Generatorpolynoms für die Kanalcodierung und/oder für die Erzeugung der Redundanzinformationen (102-n) der Nutzdaten (100-m) in den Paketkerndaten (210-n) und für die Kanalcodierung und/oder für die Erzeugung der Redundanzinformationen (102-n) der Nutzdaten (100-m) im Nutzdatenbereich (220-n) überprüft wird.

15. Sender (300) zum Übertragen von Nutzdaten (100-m) innerhalb eines Zeitintervalls (T) über einen Kommunikationskanal zu einem Empfänger (400), mit

einer Einrichtung (ENC) zum Erzeugen einer Mehrzahl kanalcodierter Datenpakete (200-n) aus den Nutzdaten (100-m), wobei

jedes der kanalcodierten Datenpakete (200-n) mit Paketkerndaten (210-n) entsprechend der Paketkennung des jeweiligen kanalcodierten Datenpakets versehen ist, und wobei

die Paketkerndaten (210-n) mit einem Kanalcode höherer Redundanz codiert sind als die Nutzdaten (100-m); und

einer Einrichtung (TX) zum Senden der Mehrzahl der kanalcodierten Datenpakete (200-n) in dem Zeitintervall (T) zu dem Empfänger (400), wobei die Einrichtung (ENC) zum Erzeugen einer Mehrzahl kanalcodierter Datenpakete (200-n) Redundanzinformationen (102-n) der Nutzdaten (100-m), insbesondere Informationen zur Fehlererkennung, insbesondere Informationen zur zyklischen Redundanzprüfung, CRC, und/oder davon abgeleitete Werte, insbesondere von Informationen zur zyklischen Redundanzprüfung, CRC, abgeleiteten Werten, als Paketkennung oder als Teil der Paketkennung in den Paketkerndaten (210-n) verwendet, und die Redundanzinformationen (102-n) der Nutzdaten (100-m), insbesondere Informationen zur Fehlererkennung, in mindestens zwei Teilen des Datenpakets (220-n), insbesondere in zwei nicht benachbarten Teilen, übertragen werden, wobei diese zwei Teile des Datenpakets (220-n) mit gleicher Coderate der Kanalkodierung codiert sind, und

wobei der Sender (300) bevorzugt mit einem Messgerät, insbesondere einem Heizungs-, Strom- oder Wasserzähler, gekoppelt ist, so dass die Messdaten des Messgeräts dem Sender (300) als Nutzdaten (100-m) bereitgestellt werden.

16. Sender (300) nach Anspruch 15, **dadurch gekennzeichnet, dass** die Einrichtung (ENC) zum Erzeugen ausgebildet ist, die kanalcodierten Datenpakete (200-n) mit jeweils unterschiedlichen Kanalcodierungen zu erzeugen.

17. Empfänger (400) zum Empfangen von Nutzdaten (100-m), die innerhalb eines Zeitintervalls (T) mittels einer Mehrzahl kanalcodierter Datenpakete (200-n) von einem Sender (300) über einen Kommunikationskanal zu dem Empfänger (400) übertragen werden, wobei

jedes der kanalcodierten Datenpakete (200-n) mit Paketkerndaten (210-n) entsprechend der Paketkennung des jeweiligen kanalcodierten Datenpakets versehen ist, und wobei die Paketkerndaten (210-n) mit einem Kanalcode höherer Redundanz codiert sind als die Nutzdaten (100-m), mit folgenden Merkmalen:

einer Einrichtung (RX) zum Empfangen der Mehrzahl der kanalcodierten Datenpakete (200-n) in dem Zeitintervall (T); und einem Decoder (DEC), der angepasst ist,

um Paketkerndaten (210-1) eines ersten empfangenen kanalcodierten Datenpakets (200-1) des Zeitintervalls (T) zu decodieren und, im Fall eines Scheiterns eines fehlerfreien Decodierens des ersten kanalcodierten Datenpakets (200-1), um Paketkerndaten (210-2) wenigstens eines zweiten empfangenen kanalcodierten Datenpakets (200-2) des Zeitintervalls (T) zu decodieren, um ein geeignetes weiteres kanalcodiertes Datenpaket (200-2) des Zeitintervalls für eine Kombination mit dem ersten kanalcodierten Datenpaket (200-1) zu ermitteln, um aufgrund der Kombination einen erhöhten Codegewinn für eine Decodierung der Nutzdaten (100-m) zu erhalten,

wobei der Decoder (DEC) zum Decodieren eines kanalcodierten Datenpakets (200-n) die Redundanzinformationen (102-n) der Nutzdaten (100-m), insbesondere Informationen zur Fehlererkennung, insbesondere Informationen zur zyklischen Redundanzprüfung, CRC, und/oder davon abgeleitete Werte, insbesondere von Informationen zur zyklischen Redundanzprüfung, CRC, abgeleiteten Werten, welche als Paketkennung oder als Teil der Paketkennung in den Paketkerndaten (210-n) dienen und in mindestens zwei Teilen des Datenpakets (220-n), insbesondere in zwei nicht benachbarten Teilen, übertragen werden, verwendet werden.

**18.** Empfänger (400) nach Anspruch 17, **dadurch ge-** **kennzeichnet, dass** der Decoder (DEC) ausgebildet ist, um durch die Decodierung eines ersten kanalkodierten Datenpakets (200-1) gewonnene Information als Redundanzinformation zur Decodierung eines zweiten und/oder eines weiteren kanalkodierten Datenpakets (200-2) zu verwenden, und/oder um einen erhöhten Codegewinn zu erhalten.

**19.** Empfänger (400) nach einem der Ansprüche 17 oder 18, **dadurch gekennzeichnet, dass** der Decoder (DEC) ausgebildet ist, um ein kanalkodiertes Datenpaket (200-n) einer vorgegebenen Gruppe von kanalcodierten Datenpaketen (200-n), die auf zugehörigen Nutzdaten (100) basieren, unabhängig von den anderen kanalkodierten Datenpaketen (200-n) der Gruppe zu decodieren, und/oder ausgebildet ist, um zumindest eine vorgegebene Auswahl von Kombinationen der kanalcodierten Datenpakete (200-n), die auf zugehörigen Nutzdaten (100) basieren, zu decodieren.

**20.** System zum Übertragen von Nutzdaten (100-m) innerhalb eines Zeitintervalls (T) von einem Sender (300) über einen Kommunikationskanal zu einem Empfänger (400) mit folgenden Merkmalen:

einem Sender (300) gemäß einem der Ansprüche 15 oder 16; und einem Empfänger (400) gemäß einem der Ansprüche 17 bis 19.

**21.** Computerprogramm zur Durchführung eines Verfahrens gemäß einem der Ansprüche 1 bis 14, wobei das Computerprogramm auf einem Rechner oder Mikrocontroller abläuft, der einem Sender (300) oder einem Empfänger (400) zugeordnet ist.

**Claims**

**1.** Method for transmitting payload data (100-m) to a receiver (400) via a communication channel within a time interval (T), having the following steps:

generating a plurality of channel-coded data packets (200-n) from the payload data (100-m), wherein each of the channel-coded data packets (200-n) is provided with packet core data (210-n) in accordance with the packet identifier of the respective channel-coded data packet, wherein redundancy information (102-n) of the payload data (100-m), in particular information relating to the error recognition, in particular information relating to the cyclic redundancy check, CRC, and/or values derived therefrom, in particular values derived from information relating to the cyclic redundancy check, CRC, is used as the packet identifier or as part of the packet identifier in the packet core data (210-n), and

the redundancy information (102-n) of the payload data (100-m), in particular information relating to the error recognition, is transmitted in at least two parts of the data packet (220-n), in particular in two non-adjacent parts, these two parts of the data packet (220-n) having been coded using the same code rate for the channel coding.

2. Method according to Claim 1, **characterized in that** a first part of the redundancy information (102-n) of the payload data (100-m) is used as the packet identifier in the packet core data (210-n) and a second part of the redundancy information (102-n) of the payload data (100-m) is transmitted in the payload data area (220-n).

3. Method according to either of Claims 1 and 2, **characterized in that** redundancy information (213-n) of the packet core data (210-n) is transmitted with the packet core data (210-n).

4. Method according to one of the preceding claims, **characterized in that** the plurality of channel-coded data packets (200-n) (T) are sent to the receiver (400) in the time interval, the plurality of channel-coded data packets (200-n) being sent in the time interval (T) independently of a return channel from the receiver (400) to the transmitter (300) in terms of content and transmission times.

5. Method according to one of the preceding claims, **characterized in that** the channel-coded data packets (200-n) are generated from the payload data (100) by means of a convolution code and a puncturing scheme, with the result that each channel-coded data packet (200-n) in a predefined group of channel-coded data packets (200-n) based on associated payload data (100) can be decoded independently of the other channel-coded data packets (200-n) in the group,

there being provision in particular for at least a predefined selection of combinations of the channel-coded data packets (200-n) based on the associated payload data (100) to be able to be decoded.

6. Method according to one of the preceding claims, **characterized in that** the redundancy information (102-n) of the payload data (100-m) is information relating to the cyclic redundancy check, CRC, in particular in the form of appended CRC values.

7. Method according to one of Claims 2 to 6, **characterized in that** at least some of the redundancy information (102-n) of the payload data (100-m), in particular the CRC data, in the packet core data (210-n) has been coded effectively using the same code rate for the channel coding as the redundancy information (102-n) of the payload data (100-m) in the payload data area (220-n),

there being provision in particular for at least one first part of the packet core data (210-n) to have been coded using a channel code with higher redundancy than the channel-coded payload data (221-n) in a payload data area (220-n) and for at least one second part of the packet core data (210-n) to have been coded using a channel code with the same redundancy as the channel-coded payload data (221-n) in the payload data area (220-n), the first part of the packet core data (210-n), which has been coded using a channel code with higher redundancy than the channel-coded payload data (221-n) in the payload data area (220-n), preferably being used as the packet identifier in the packet core data (210-n).

8. Method according to Claim 7, **characterized in that** the redundancy information (102-n) of the payload data (100-m), in particular the CRC data, is prepared for transmission in the packet core data (210-n):

coding of the redundancy information (102-n) of the payload data (100-m), in particular the CRC data, using the channel code of the payload data (100);

transformation of the redundancy information (102-n) of the payload data (100-m) that has been coded using the channel code of the payload data (100) in order to subsequently be coded using the channel code of the packet core data (210-n).

9. Method according to one of Claims 2 to 6, **characterized in that** a common generator polynomial is used for the channel coding of the redundancy information (102-n), in particular the CRC data, of the payload data (100-m) in the packet core data (210-n) and for the channel coding of the redundancy information (102-n), in particular the CRC data, of the payload data (100-m) in the payload data area (220-n), there being provision in particular for a generator polynomial with a higher degree to be used to generate all of the partial generator polynomials with a lower degree, a partial generator polynomial being used for the channel coding and/or for generating the redundancy information (102-n) of the payload data (100-m) in the packet core data (210-n).

10. Method according to one of Claims 2 to 6, **characterized in that** a common generator polynomial is used to generate the redundancy information (102-n), in particular information relating to the error recognition, in particular information relating to the cyclic redundancy check, CRC, of the payload data (100-m) in the packet core data (210-n) and to generate the redundancy information (102-n), in particular information relating to the error recognition, in particular information relating to the cyclic redundancy check, CRC, of the payload data (100-m) in the payload data area (220-n),

there being provision in particular for a generator polynomial with a higher degree to be used to generate all of the partial generator polynomials with a lower degree, a partial generator polynomial being used for the channel coding and/or for generating the redundancy information (102-n) of the payload data (100-m) in the packet core data (210-n).

11. Method for receiving payload data (100-m), having the following features:

receiving a plurality of channel-coded data packets (200-n) in the time interval (T);
decoding packet core data (210-1) of a first channel-coded data packet (200-1) of the time interval (T);
and,
if a decoding of the first channel-coded data packet (200-1) fails,
decoding packet core data (210-2) of at least one second channel-coded data packet (200-2) of the time interval (T), in order to ascertain a suitable further channel-coded data packet of the time interval for a combination with the first channel-coded data packet,
in order to take the combination as a basis for obtaining an increased coding gain for decoding the payload data, wherein
the payload data (100-m) are transmitted via a communication channel, and
a channel-coded data packet (200-n) is decoded by using the redundancy information (102-n) of the payload data (100-m), in particular information relating to the error recognition, information relating to the cyclic redundancy check, CRC, and/or values derived therefrom,
in particular values derived from information relating to the cyclic redundancy check, CRC, which redundancy information is used as the packet identifier or as part of the packet identifier in the packet core data (210-n) and is transmitted in at least two parts of the data packet (220-n), in particular in two non-adjacent parts.

12. Method according to Claim 11, **characterized in that** one channel-coded data packet (200-n) in a predefined group of channel-coded data packets (200-n) based on associated payload data (100) is decoded independently of the other channel-coded data packets (200-n) in the group, or **in that** a predefined selection of combinations of the channel-coded data packets (200-n) based on associated payload data (100) is decoded.

13. Method according to either of Claims 11 and 12, **characterized in that** the decoding of a channel-coded data packet (200-1) is checked by performing a bit comparison between the redundancy information (102-1, 102-2) of the payload data (100-m) and at least one second channel-coded data packet (200-2) of the time interval (T),

wherein there is provision in particular for a bit comparison between the redundancy information (102-1, 102-2) of the payload data (100-m) in the respective packet core data (210-1, 210-2) and/or for a bit comparison between the redundancy information (102-1, 102-2) of the payload data (100-m) in the respective payload data areas (220-1, 220-2).

14. Method according to one of the preceding Claims 11 to 13, **characterized in that** the use of a common generator polynomial for the channel coding and/or for generating the redundancy information (102-n) of the payload data (100-m) in the packet core data (210-n) and for the channel coding and/or for generating the redundancy information (102-n) of the payload data (100-m) in the payload data area (220-n) is checked.

15. Transmitter (300) for transmitting payload data (100-m) to a receiver (400) via a communication channel within a time interval (T), having

a device (ENC) for generating a plurality of channel-coded data packets (200-n) from the payload data (100-m), wherein
each of the channel-coded data packets (200-n) is provided with packet core data (210-n) in accordance with the packet identifier of the respective channel-coded data packet, and wherein
the packet core data (210-n) are coded using a channel code with higher redundancy than the payload data (100-m); and
a device (TX) for sending the plurality of channel-coded data packets (200-n) to the receiver (400) in the time interval (T),
wherein
the device (ENC) for generating a plurality of channel-coded data packets (200-n) uses redundancy information (102-n) of the payload data (100-m), in particular information relating to the error recognition, in particular information relating to the cyclic redundancy check, CRC, and/or values derived therefrom, in particular values derived from information relating to the cyclic redundancy check, CRC, as the packet identifier or as part of the packet identifier in the packet core data (210-n), and
the redundancy information (102-n) of the payload data (100-m), in particular information relating to the error recognition, is transmitted in at least two parts of the data packet (220-n), in particular in two non-adjacent parts, these two parts of the data packet (220-n) having been coded using the same code rate for the channel coding, and

wherein the transmitter (300) is preferably coupled to a measuring instrument, in particular a heating, electricity or water meter, with the result that the measurement data from the measuring instrument are provided to the transmitter (300) as payload data (100-m) .

16. Transmitter (300) according to Claim 15, **characterized in that** the device (ENC) for generating is designed to generate the channel-coded data packets (200-n) using respective different channel codings.

17. Receiver (400) for receiving payload data (100-m) that are transmitted to the receiver (400) by a transmitter (300) via a communication channel within a time interval (T) by means of a plurality of channel-coded data packets (200-n), wherein

each of the channel-coded data packets (200-n) is provided with packet core data (210-n) in accordance with the packet identifier of the respective channel-coded data packet, and wherein
the packet core data (210-n) are coded using a channel code with higher redundancy than the payload data (100-m), having the following features:

a device (RX) for receiving the plurality of channel-coded data packets (200-n) in the time interval (T); and
a decoder (DEC) that is customized
in order to decode packet core data (210-1) of a first received channel-coded packet (200-1) of the time interval (T) and, if an error-free decoding of the first channel-coded data packet (200-1) fails,
in order to decode packet core data (210-2) of at least one second received channel-coded data packet (200-2) of the time interval (T),
in order to ascertain a suitable further channel-coded data packet (200-2) of the time interval for a combination with the first channel-coded data packet (200-1) ,
in order to take the combination as a basis for obtaining an increased coding gain for decoding the payload data (100-m),
wherein the decoder (DEC) decodes a channel-coded data packet (200-n) by using the redundancy information (102-n) of the payload data (100-m), in particular information relating to the error recognition, in particular information relating to the cyclic redundancy check, CRC, and/or values derived therefrom, in particular values derived from information relating to the cyclic redundancy check, CRC, which redundancy information is used as the packet identifier or as part of the packet identifier in the packet core data (210-n) and is transmitted in at least two parts of the data packet (220-n), in particular in two non-adjacent parts.

18. Receiver (400) according to Claim 17, **characterized in that** the decoder (DEC) is designed to use information obtained as a result of the decoding of a first channel-coded data packet (200-1) as redundancy information for decoding a second and/or a further channel-coded data packet (200-2), and/or to obtain an increased coding gain.

19. Receiver (400) according to either of Claims 17 and 18, **characterized in that** the decoder (DEC) is designed to decode one channel-coded data packet (200-n) in a predefined group of channel-coded data packets (200-n) based on associated payload data (100) independently of the other channel-coded data packets (200-n) in the group, and/or is designed to decode at least a predefined selection of combinations of the channel-coded data packets (200-n) based on associated payload data (100).

20. System for transmitting payload data (100-m) from a transmitter (300) to a receiver (400) via a communication channel within a time interval (T), having the following features:

a transmitter (300) according to either of Claims 15
and 16; and
a receiver (400) according to one of Claims 17 to 19.

21. Computer program for carrying out a method according to the one of Claims 1 to 14, wherein the computer program runs on a computer or microcontroller that is associated with a transmitter (300) or with a receiver (400).

**Revendications**

1. Procédé permettant de transmettre des données utiles (100-m) dans un intervalle de temps (T) sur un canal de communication à un récepteur (400), comprenant les étapes suivantes consistant à :

générer une pluralité de paquets de données codées par canal (200-n) à partir des données utiles (100-m), dans lequel

chacun des paquets de données codées par canal (200-n) est pourvu de données de paquet essentielles (210-n) selon l'identifiant de paquet du paquet de données codées par canal respectif,

dans lequel des informations de redondance (102-n) des données utiles (100-m), en particulier des informations de détection des erreurs, en particulier des informations de contrôle de redondance cyclique, CRC,

et/ou des valeurs dérivées de celles-ci, en particulier des valeurs dérivées des informations de contrôle de redondance cyclique, CRC, sont utilisées comme identifiant de paquet ou comme une partie de l'identifiant de paquet dans les données de paquet essentielles (210-n), et

les informations de redondance (102-n) des données utiles (100-m), en particulier des informations de détection des erreurs, sont transmises dans au moins deux parties du paquet de données (220-n), en particulier dans deux parties non voisines, dans lequel ces deux parties du paquet de données (220-n) sont codées avec le même taux de codage que le codage de canal.

2. Procédé selon la revendication 1, **caractérisé en ce qu'**une première partie des informations de redondance (102-n) des données utiles (100-m) est utilisée comme identifiant de paquet dans les données de paquet essentielles (210-n) et une deuxième partie des informations de redondance (102-n) des données utiles (100-m) est transmise dans la plage de données utiles (220-n).

3. Procédé selon l'une quelconque des revendications 1 ou 2, **caractérisé en ce que** des informations de redondance (213-n) des données de paquet essentielles (210-n) sont transmises avec les données de paquet essentielles (210-n).

4. Procédé selon l'une quelconque des revendications précédentes, **caractérisé en ce que** la pluralité des paquets de données codées par canal (200-n) est envoyée dans l'intervalle de temps (T) au récepteur (400), dans lequel l'envoi de la pluralité des paquets de données codées par canal (200-n) a lieu compte tenu du contenu et des temps d'envoi indépendamment d'un canal de retour du récepteur (400) à l'émetteur (300) dans l'intervalle de temps (T).

5. Procédé selon l'une quelconque des revendications précédentes, **caractérisé en ce que** les paquets de données codées par canal (200-n) sont générés au moyen d'un code de convolution et d'un schéma de poinçonnage à partir des données utiles (100) de sorte que chaque paquet de données codées par canal (200-n) d'un groupe prédéfini de paquets de données codées par canal (200-n) qui sont basés sur des données utiles (100) associées peut être décodé indépendamment des autres paquets de données codées par canal (200-n) du groupe, dans lequel il est prévu en particulier qu'au moins une sélection prédéfinie de combinaisons des paquets de données codées par canal (200-n) qui sont basés sur les données utiles (100) associées pourra être décodée.

6. Procédé selon l'une quelconque des revendications précédentes, **caractérisé en ce que** les informations de redondance (102-n) des données utiles (100m) sont des informations concernant le contrôle de redondance cyclique, CRC, en particulier sous la forme de valeurs CRC ajoutées.

7. Procédé selon l'une quelconque des revendications 2 à 6, **caractérisé en ce qu'**au moins une partie des informations de redondance (102-n) des données utiles (100-m), en particulier les données CRC, dans les données de paquet essentielles (210-n) est effectivement codée avec le même taux de codage du codage de canal que les informations de redondance (102-n) des données utiles (100-m) dans la plage de données utiles (220-n),

dans lequel il est prévu en particulier qu'au moins une première partie des données de paquet essentielles (210-n) sera codée avec un code de canal d'une redondance supérieure à celle des données utiles codées par canal (221-n) dans une plage de données utiles (220-n), et qu'au moins une deuxième partie des données de paquet essentielles (210-n) sera codée avec un code de canal d'une redondance identique à celle des données utiles codées par canal (221-n) dans la plage de données utiles (220-n), dans lequel la première partie des données de paquet essentielles (210-n) qui est codée avec un code de canal d'une redondance supérieure à celle des données utiles codées par canal (221-n) dans la plage de données utiles (220-n) sera utilisée de préférence comme un identifiant de paquet dans les données de paquet essentielles (210-n).

8. Procédé selon la revendication 7, **caractérisé en ce que** les informations de redondance (102-n) des données utiles (100-m), en particulier les données CRC, sont préparées à la transmission dans les données de paquet essentielles (210-n) :

codage des informations de redondance (102-n) des données utiles (100-m), en particulier des données CRC, avec le code de canal des données utiles (100) ;
transformation des informations de redondance (102-n) des données utiles (100-m), codées avec le code de canal des données utiles (100), afin d'être codées ensuite avec le code de canal des données de paquet essentielles (210-n).

9. Procédé selon l'une quelconque des revendications 2 à 6, **caractérisé en ce qu'**un polynôme générateur commun est utilisé pour le codage de canal des informations de redondance (102-n), en particulier des données CRC, des données utiles (100-m) dans les données de paquet essentielles (210-n), et pour le codage de canal des informations de redondance (102-n), en particulier des données CRC, des données utiles (100-m) dans la plage de données utiles (220-n), dans lequel il est prévu en particulier que tous les polynômes générateurs partiels d'un degré inférieur seront générés à partir d'un polynôme générateur d'un degré supérieur, dans lequel un polynôme générateur partiel est utilisé pour le codage de canal et/ou pour la génération des informations de redondance (102-n) des données utiles (100-m) dans les données de paquet essentielles (210-n).

10. Procédé selon l'une quelconque des revendications 2 à 6, **caractérisé en ce qu'**un polynôme générateur commun est utilisé pour la génération des informations de redondance (102-n), en particulier des informations de détection des erreurs, en particulier des informations de contrôle de redondance cyclique, CRC, des données utiles (100-m) dans les données de paquet essentielles (210-n), et pour la génération des informations de redondance (102-n), en particulier des informations de détection des erreurs, en particulier des informations de contrôle de redondance cyclique, CRC, des données utiles (100-m) dans la plage de données utiles (220-n), dans lequel il est prévu en particulier que tous les polynômes générateurs partiels d'un degré inférieur seront générés à partir d'un polynôme générateur d'un degré supérieur, dans lequel un polynôme générateur partiel est utilisé pour le codage de canal et/ou pour la génération des informations de redondance (102-n) des données utiles (100-m) dans les données de paquet essentielles (210-n).

11. Procédé permettant de recevoir des données utiles (100-m), comprenant les particularités suivantes consistant à :

   recevoir une pluralité de paquets de données codées par canal (200-n) dans un intervalle de temps (T) ;
   décoder des données de paquet essentielles (210-1) d'un premier paquet de données codées par canal (200-1) de l'intervalle de temps (T) ; et
   en cas d'échec d'un décodage du premier paquet de données codées par canal (200-1),
   décoder des données de paquet essentielles (210-2) d'au moins un deuxième paquet de données codées par canal (200-2) de l'intervalle de temps (T) afin d'établir un autre paquet de données codées par canal de l'intervalle de temps adapté pour une combinaison avec le premier paquet de données codées par canal afin d'obtenir sur la base de la combinaison un gain de codage accru pour un décodage des données utiles,
   dans lequel les données utiles (100-m) sont transmises sur un canal de communication, et pour le décodage d'un paquet de données codées par canal (200-n), on utilise les informations de redondance (102-n) des données utiles (100-m), en particulier des informations de détection des erreurs, en particulier des informations de contrôle de redondance cyclique, CRC, et/ou des valeurs dérivées de celles-ci, en particulier des valeurs dérivées des informations de contrôle de redondance cyclique, CRC, qui servent d'identifiant de paquet ou de partie de l'identifiant de paquet dans les données de paquet essentielles (210-n) et sont transmises dans au moins deux parties du paquet de données (220-n), en particulier dans deux parties non voisines.

12. Procédé selon la revendication 11, **caractérisé en ce qu'**un paquet de données codées par canal (200-n) d'un groupe prédéfini de paquets de données codées par canal (200-n), qui sont basés sur des données utiles (100) associées, est décodé indépendamment des autres paquets de données codées par canal (200-n) du groupe, ou **en ce qu'**une sélection prédéfinie de combinaisons des paquets de données codées par canal (200-n), qui sont basés sur des données utiles (100) associées, est décodée.

13. Procédé selon l'une quelconque des revendications 11 ou 12, **caractérisé en ce qu'**une comparaison de bits des informations de redondance (102-1, 102-2) des données utiles (100-m) avec au moins un deuxième paquet de données codées par canal (200-2) de l'intervalle de temps (T) est effectuée pour le contrôle du décodage d'un paquet de données codées par canal (200-1), dans lequel il est prévu en particulier qu'une comparaison de bits des informations de redondance (102-1, 102-2) des données utiles (100-m) dans les données de paquet essentielles (210-1, 210-2) respectives et/ou une comparaison de bits des informations de redondance (102-1, 102-2) des données utiles (100-m) dans les plages de données utiles (220-1, 2202) respective seront effectuées.

14. Procédé selon l'une quelconque des revendications précédentes 11 à 13, **caractérisé en ce que** l'utilisation d'un polynôme générateur commun pour le codage de canal et/ou pour la génération des informations de redondance (102-n) des données utiles (100-m) dans les données de paquet essentielles (210-n) et pour le codage de canal et/ou pour la génération des informations de redondance (102-n) des données utiles (100-m) dans la plage de données utiles (220-n) est contrôlée.

15. Emetteur (300) permettant de transmettre des données utiles (100-m) dans un intervalle de temps (T) sur un canal de communication à un récepteur (400), comprenant

un dispositif (ENC) permettant de générer une pluralité de paquets de données codées par canal (200-n) à partir des données utiles (100-m), dans lequel

chacun des paquets de données codées par canal (200-n) est pourvu de données de paquet essentielles (210-n) selon l'identifiant de paquet du paquet de données codées par canal respectif, et dans lequel les données de paquet essentielles (210-n) sont codées par un code de canal d'une redondance supérieure à celle des données utiles (100-m) ; et un dispositif (TX) permettant d'émettre la pluralité des paquets de données codées par canal (200-n) dans l'intervalle de temps (T) au récepteur (400),

dans lequel le dispositif (ENC) permettant de générer une pluralité de paquets de données codées par canal (200-n) utilise des informations de redondance (102-n) des données utiles (100-m), en particulier des informations de détection des erreurs, en particulier des informations de contrôle de redondance cyclique, CRC, et/ou des valeurs dérivées de celles-ci, en particulier des valeurs dérivées des informations de contrôle de redondance cyclique, CRC, comme identifiant de paquet ou comme une partie de l'identifiant de paquet dans les données de paquet essentielles (210-n), et les informations de redondance (102-n) des données utiles (100-m), en particulier les informations de détection des erreurs, sont transmises dans au moins deux parties du paquet de données (220-n), en particulier dans deux parties non voisines, dans lequel ces deux parties du paquet de données (220-n) sont codées avec le même taux de codage que le codage de canal, et dans lequel l'émetteur (300) est couplé de préférence à un appareil de mesure, en particulier à un compteur de chauffage, d'électricité ou d'eau, de sorte que les données de mesure de l'appareil de mesure sont fournies à l'émetteur (300) sous forme de données utiles (100-m).

16. Emetteur (300) selon la revendication 15, **caractérisé en ce que** le dispositif (ENC) de génération est réalisé pour générer les paquets de données codées par canal (200-n) avec des codages de canal respectivement différents.

17. Récepteur (400) permettant de recevoir des données utiles (100-m) qui sont transmises dans un intervalle de temps (T) au moyen d'une pluralité de paquets de données codées par canal (200-n) d'un émetteur (300) sur un canal de communication au récepteur (400), dans lequel chacun des paquets de données codées par canal (200-n) est pourvu de données de paquet essentielles (210-n) selon l'identifiant de paquet du paquet de données codées par canal respectif, et dans lequel les données de paquet essentielles (210-n) sont codées avec un code de canal d'une redondance supérieure à celle des données utiles (100-m), ayant les particularités suivantes :

un dispositif (RX) permettant de recevoir la pluralité des paquets de données codées par canal (200-n) dans l'intervalle de temps (T) ; et un décodeur (DEC) qui est adapté pour

décoder des données de paquet essentielles (210-1) d'un premier paquet de données codées par canal (200-1) reçu, issu de l'intervalle de temps (T), et en cas d'échec d'un décodage sans erreur du premier paquet de données codées par canal (200-1), décoder des données de paquet essentielles (210-2) d'au moins un deuxième paquet de données codées par canal (200-2) reçu, issu de l'intervalle de temps (T), établir un autre paquet de données codées par canal (200-2) adapté, issu de l'intervalle de temps, pour une combinaison avec le premier paquet de données codées par canal (200-1), afin d'obtenir sur la base de la combinaison un gain de codage accru pour un décodage des données utiles (100-m),

dans lequel le décodeur (DEC) utilise pour le décodage d'un paquet de données codées par canal (200-n) les informations de redondance (102-n) des données utiles (100-m), en particulier les informations de détection des erreurs, en particulier les informations de contrôle de redondance cyclique, CRC, et/ou des valeurs dérivées de celles-ci, en particulier des valeurs dérivées des informations de contrôle de redondance cyclique, CRC, qui servent d'identifiant de paquet ou

comme une partie de l'identifiant de paquet dans les données de paquet essentielles (210-n) et sont transmises dans au moins deux parties du paquet de données (220-n), en particulier dans deux parties non voisines.

18. Récepteur (400) selon la revendication 17, **caractérisé en ce que** le décodeur (DEC) est réalisé pour utiliser des informations obtenues par le décodage d'un premier paquet de données codées par canal (200-1) comme informations de redondance pour le décodage d'un deuxième et/ou d'un autre paquet de données codées par canal (200-2) et/ou pour obtenir un gain de codage accru.

19. Récepteur (400) selon l'une quelconque des revendications 17 ou 18, **caractérisé en ce que** le décodeur (DEC) est réalisé pour décoder un paquet de données codées par canal (200-n) d'un groupe prédéfini de paquets de données codées par canal (200-n) qui sont basés sur des données utiles (100) associées, indépendamment des autres paquets de données (200-n) codés par canal du groupe, et/ou est réalisé pour décoder au moins une sélection prédéfinie de combinaisons des paquets de données codées par canal (200-n) qui sont basés sur des données utiles (100) associées.

20. Système permettant de transmettre des données utiles (100-m) dans un intervalle de temps (T) d'un émetteur (300) sur un canal de communication à un récepteur (400), ayant les particularités suivantes :

    un émetteur (300) selon l'une quelconque des revendications 15 ou 16 ; et
    un récepteur (400) selon l'une quelconque des revendications 17 à 19.

21. Programme informatique permettant d'exécuter un procédé selon l'une quelconque des revendications 1 à 14, dans lequel le programme informatique fonctionne sur un ordinateur ou un microcontrôleur qui est associé à un émetteur (300) ou à un récepteur (400).

Fig. 1

EP 3 917 048 B1

| 211 | • • • | 213 | 221 | • • • | 222 |

| 212 | • • • | 213 | 221 | • • • | 222 |

210          220

200

Fig. 2

Fig. 3

EP 3 917 048 B1

100 → 102 （30 Bit）

14 Bit　　16 Bit

ENC $R_k = \frac{1}{3}$　　　ENC $R_n = \frac{7}{8}$

（42 Bit） 212 ENC　　222 ENC （19 Bit）

| 212 | · · · | 213 | 221 | · · · | 222 |

200

210　　　220

Fig. 4a

Fig. 4b

Fig. 4c

EP 3 917 048 B1

Fig. 5

$$p_1 = 1 + x^5 + x^{14}$$

$$p_2 = 1 + x^5 + x^{12} + x^{16}$$

14 Bit

16 Bit

| 212 | • • • | 213 | 221 | • • • | 222 |

210

220

200

Fig. 6a

EP 3 917 048 B1

| 16 LS Bits | 16 MS Bits |
|------------|------------|

16 Bit          32 Bit          16 Bit

$$p_{ges} = 1 + x^1 + x^2 + x^4 + x^5 + x^7 + x^8 + x^{10} + x^{11} + x^{12} + x^{16} + x^{22} + x^{23} + x^{26} + x^{32}$$

| 212 | • • • | 213 | 221 | • • • | 222 |
|-----|-------|-----|-----|-------|-----|

210                          220

200

Fig. 6b

212

222

16 Bit

16 Bit

16 Bit

Auf eigenes
Generatorpolynom
prüfen

✖ Ok? ✔ → fertig

32 Bit

Auf gemeinsames
Generatorpolynom
prüfen

✖ Ok? ✔ → fertig

Fig. 7

**IN DER BESCHREIBUNG AUFGEFÜHRTE DOKUMENTE**

**In der Beschreibung aufgeführte Patentdokumente**

- DE 102010031411 B4

- WO 2017035297 A1

**In der Beschreibung aufgeführte Nicht-Patentliteratur**

- Adopting FEC and packet combining to increase the performance of IWSNs using relaying. **GIRS SVETLANA et al.** 2015 INTERNATIONAL CONFERENCE ON COMPUTING AND NETWORK COMMUNICATION (COCONET). IEEE, 16. Dezember 2015, 90-97